# EUROPEAN PATENT APPLICATION

(11) **EP 4 783 772 A2**
(43) Date of publication of application: **29.07.2026**
(21) Application number: 26152114.0
(22) Date of filing: 15.01.2026
(51) Int. Cl.: H10D 84/01, H10D 30/01, H10D 30/00, H10D 84/03, H10D 84/83, H10D 84/85, H10D 62/10

(54) **SEMICONDUCTOR DEVICE INCLUDING TRANSISTOR STRUCTURE AND SEPARATION STRUCTURE**

(30) Priority: 23.01.2025 KR 20250010596
(71) Applicant: Samsung Electronics Co., Ltd., Suwon-si, Gyeonggi-do 16677 (KR)
(72) Inventor: PARK, Wooseok, 16677 Suwon-si (KR); CHOI, Woohyeon, 16677 Suwon-si (KR); LEE, Yonghui, 16677 Suwon-si (KR); SONG, Hyewon, 16677 Suwon-si (KR); PARK, Kyunam, 16677 Suwon-si (KR); KOO, Jehyoung, 16677 Suwon-si (KR)
(74) Representative: Marks & Clerk LLP

(57) **Abstract**

A semiconductor device (1) includes a separation structure (51) and a transistor structure (T1; T2; T3; T4) on a side surface (51S1; 51S2) of the separation structure (51). The transistor structure (T1; T2; T3; T4) includes a first source/drain region (54a), a second source/drain region (54b) spaced apart from the first source/drain region (54a), channel layers (9) connected to the first source/drain region (54a) and the second source/drain region (54b), the channel layers (9) being spaced apart in a first direction, a gate electrode (81; 82) covering each of the channel layers (9), a gate dielectric structure (79) between the first source/drain region (54a) and the second source/drain region (54b) and the gate electrode (81; 82), between the channel layers (9) and the gate electrode (81; 82), and between the separation structure (51) and the gate electrode (81; 82), and a first insulating spacer (45a) and a second insulating spacer (45b) spaced apart from each other, adjacent to the separation structure (51), and between the first source/drain region (54a) and the second source/drain region (54b).

## Description

### BACKGROUND

The present disclosure relates to a semiconductor device including a transistor structure and a separation structure.

As demand for high performance, high speed, and/or multifunctionality of semiconductor devices increases, the integration of semiconductor devices has increased. In order to manufacture semiconductor devices with fine patterns corresponding to the trend toward high integration of semiconductor devices, implementing patterns having fine widths or fine gaps has become important. In addition, efforts have been made to develop semiconductor devices including transistors having a three-dimensional channel structure in order to overcome the limitations of operating characteristics due to the reduction in a size of a planar metal oxide semiconductor field effect transistors (MOSFET).

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

One or more example embodiments provide a semiconductor device that may be capable of increasing integration and improved performance, as well as a method of manufacturing the same.

Additional aspects will be set forth in part in the description which follows and, in part, will be apparent from the description, or may be learned by practice of the presented embodiments.

According to an aspect of an example embodiment, a semiconductor device includes a separation structure and a transistor structure on a side surface of the separation structure. The transistor structure includes a first source/drain region, a second source/drain region spaced apart from the first source/drain region, channel layers connected to the first source/drain region and the second source/drain region, the channel layers being spaced apart in a first direction, a gate electrode covering each of the channel layers, a gate dielectric structure between the first source/drain region and the second source/drain region and the gate electrode, between the channel layers and the gate electrode, and between the separation structure and the gate electrode, and a first insulating spacer and a second insulating spacer spaced apart from each other, adjacent to the separation structure, and between the first source/drain region and the second source/drain region.

According to an aspect of an example embodiment, a semiconductor device may include a separation structure having a first side surface and a second side surface opposite to the first side surface in a first direction, a first transistor structure on the first side surface of the separation structure and a second transistor structure on the second side surface of the separation structure, where each of the first transistor structure and the second transistor structure includes channel layers stacked and spaced apart from each other in a second direction intersecting the first direction, and respectively having a first side surface facing the separation structure and a second side surface opposite the first side surface, a gate electrode covering an upper surface, a lower surface, and the first side surface of each of the channel layers, and a gate dielectric structure between the channel layers and the gate electrode, and between the separation structure and the gate electrode, where, in each of the first transistor structure and the second transistor structure, the gate electrode includes a lower electrode portion below a lower surface of a lowermost channel layer among the channel layers in the second direction, an upper electrode portion on an upper surface of an uppermost channel layer among the channel layers in the second direction, and an intermediate electrode portion between channel layers, among the channel layers, that are adjacent to each other in the second direction and between the uppermost channel layer and the lowermost channel layer, and a distance between the intermediate electrode portion of the gate electrode of the first transistor structure and the intermediate electrode portion of the gate electrode of the second transistor structure is less than a distance between the uppermost channel layer of the first transistor structure and the uppermost channel layer of the second transistor structure.

According to an aspect of an example embodiment, a semiconductor device may include a separation structure having a first side surface and a second side surface opposite to the first side surface in a first direction, a first transistor structure on the first side surface of the separation structure and a second transistor structure on the second side surface of the separation structure, where each of the first transistor structure and the second transistor structure includes a first source/drain region and a second source/drain region spaced apart from each other in a second direction that is perpendicular to the first direction, channel layers connected to the first source/drain region and the second source/drain region, the channel layers being spaced apart from each other in a third direction intersecting the first direction and the second direction, and respectively having a first side surface facing the separation structure and a second side surface opposing the first side surface, a gate electrode covering an upper surface, a lower surface, and the first side surface of each of the channel layers, and a gate dielectric structure between the first source/drain region and the second source/drain region and the gate electrode, between the channel layers and the gate electrode, and between the separation structure and the gate electrode, where the separation structure includes a first separation region between the gate electrode of the first transistor structure and the gate electrode of the second transistor structure, and where the first separation region includes a first separation pattern between the channel layers of the first transistor structure and the channel layers of the second transistor structure, and having a first width and a second separation pattern at a level higher than the channel layers, on the first separation pattern, and having a second width that is greater than the first width.

At least some of the above and other features of the invention are set out in the claims.

### BRIEF DESCRIPTION OF DRAWINGS

The above and other aspects, features, and advantages of certain example embodiments of the present disclosure will be more apparent from the following description taken in conjunction with the accompanying drawings, in which:
FIG. 1A is a plan view of a semiconductor device according to one or more embodiments;
FIG. 1B is a partially enlarged view illustrating a region indicated by 'A1' in FIG. 1A;
FIG. 2A is a plan view of a semiconductor device according to one or more embodiments;
FIG. 2B is a partially enlarged view illustrating a region indicated by 'A2' in FIG. 2A;
FIG. 3A is a cross-sectional view illustrating a region taken along line I-I' of FIGS. 1A and 2A;
FIG. 3B is a partially enlarged view illustrating a region indicated by 'B' in FIG. 3A;
FIG. 4 is a cross-sectional view illustrating a region taken along line II-II' of FIG. 1A and FIG. 2A;
FIG. 5A is a cross-sectional view illustrating a region taken along line III-III' of FIG. 1A and FIG. 2A;
FIG. 5B is a partially enlarged view illustrating a region indicated by 'C' of FIG. 5A;
FIG. 6 is an enlarged plan view illustrating a semiconductor device according to one or more embodiments;
FIG. 7 is an enlarged plan view illustrating a semiconductor device according to one or more embodiments;
FIG. 8 is an enlarged cross-sectional view illustrating a semiconductor device according to one or more embodiments;
FIG. 9 is an enlarged cross-sectional view illustrating a semiconductor device according to one or more embodiments;
FIG. 10 is an enlarged cross-sectional view illustrating a semiconductor device according to one or more embodiments;
FIG. 11 is an enlarged cross-sectional view a semiconductor device according to one or more embodiments;
FIGS. 12, 13 and 14 are cross-sectional views illustrating a semiconductor device according to one or more embodiments;
FIG. 15 is a partial cross-sectional view illustrating a semiconductor device according to one or more embodiments;
FIG. 16 is a partial cross-sectional view illustrating a semiconductor device according to one or more embodiments; and
FIGS. 17, 18, 19, 20, 21, 22, 23, 24A, 24B, 24C, 25, 26A, 26B, 26C, 27A, 27B, 28, 29, 30, 31A, 31B, 31C, 32A, 32B, 33A, 33B, 34 and 35 are diagrams illustrating a method of manufacturing a semiconductor device according to one or more embodiments.

### DETAILED DESCRIPTION

Hereinafter, example embodiments of the disclosure will be described in detail with reference to the accompanying drawings. The same reference numerals are used for the same components in the drawings, and redundant descriptions thereof will be omitted. The embodiments described herein are example embodiments, and thus, the disclosure is not limited thereto and may be realized in various other forms.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

Hereinafter, the terms such as "upper," "intermediate," and "lower" may be replaced with other terms such as "first," "second," and "third" and may be used to describe elements of the specification. The terms such as "first," "second," and "third" may be used to describe various elements, but the elements are not limited thereto, and the "first element" could be termed "second element." In the specification, terms such as 'lower portion,' 'upper portion,' 'upper end,' and 'lower end' may be terms described based on the drawings.

Terms such as first, second, etc. may be used to describe various components, but are used only for the purpose of distinguishing one component from another component. These terms do not limit the difference in the material or structure of the components.

The terms of a singular form may include plural forms unless otherwise specified. In addition, when a certain part "includes" a certain component, it means that other components may be further included rather than excluding other components unless otherwise stated.

The use of the term "the" and similar designating terms may correspond to both the singular and the plural.

Operations of a method may be performed in an appropriate order unless explicitly described in terms of order. In addition, the use of all illustrative terms (e.g., etc.) is merely for describing technical ideas in detail, and the scope is not limited by these examples or illustrative terms unless limited by the claims.

In the specification, a "transistor structure" may include first elements included in a transistor (e.g., a channel layer, a source/drain region, a gate dielectric structure, and a gate electrode), and second elements in contact with or adjacent to the transistor (e.g., a gate spacer, an insulating spacer, an insulating pattern, an insulating structure, a gate capping pattern, and the like). However, embodiments of the disclosure are not limited thereto.

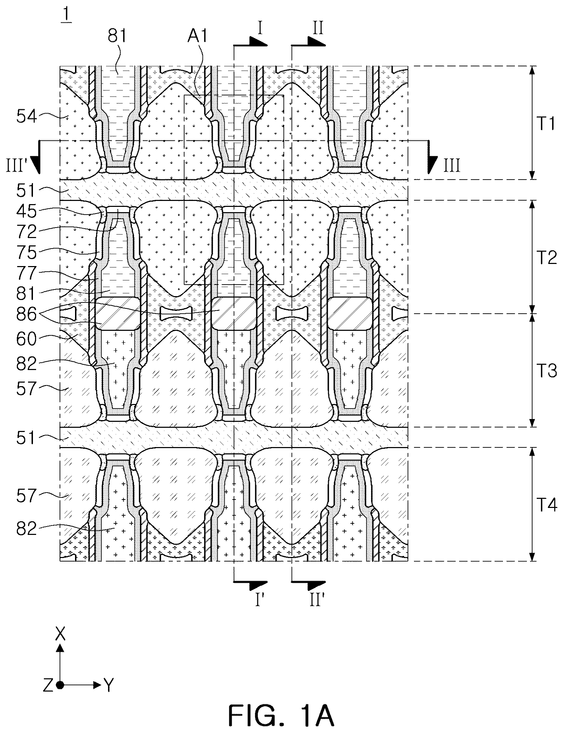

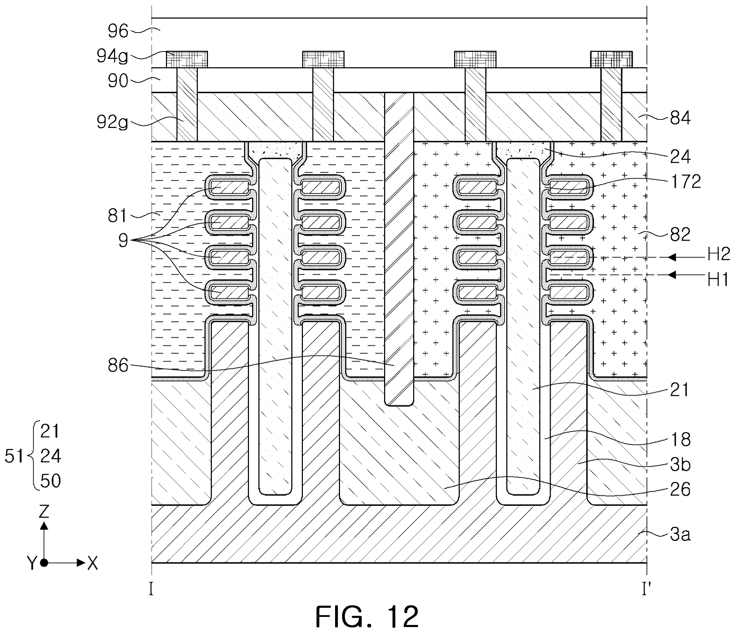

Hereinafter, example embodiments of a separation structure and a transistor structure will be described with reference to FIGS. 1A, 1B, 2A, 2B, 3A, 3B, 4, 5A, 5B, 6, 7, 8, 9, 10 and 11, and example embodiments of an interconnection structure electrically connected to elements of a transistor will be described with reference to FIGS. 12, 13, 14, 15 and 16.

FIGS. 1A, 1B, 2A, 2B, 3A, 3B, 4, 5A and 5B are diagrams illustrating a semiconductor device according to one or more embodiments.

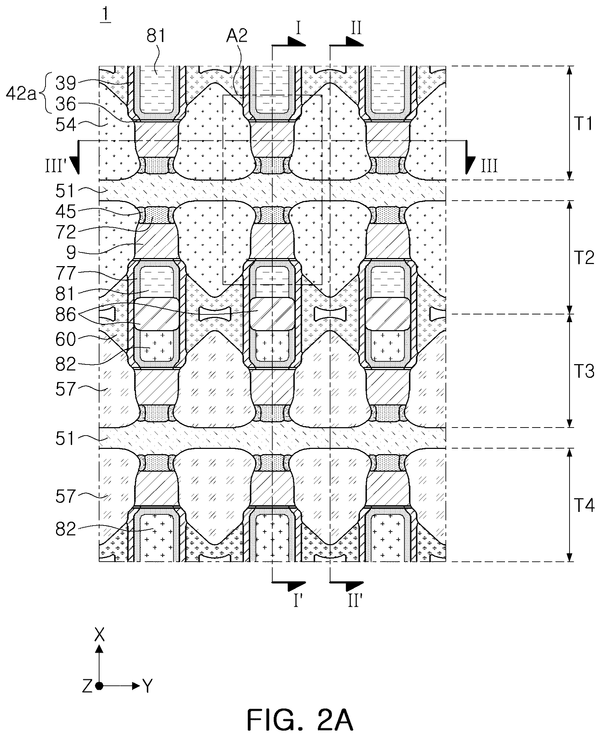

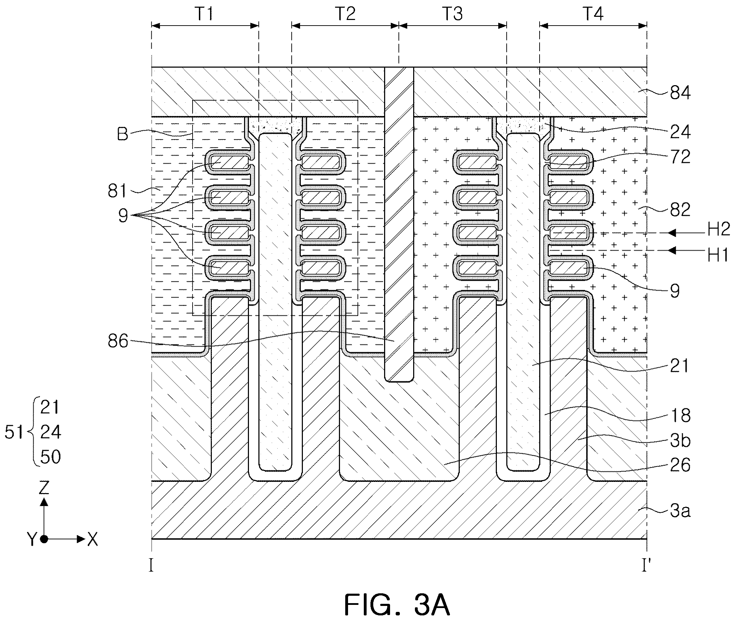

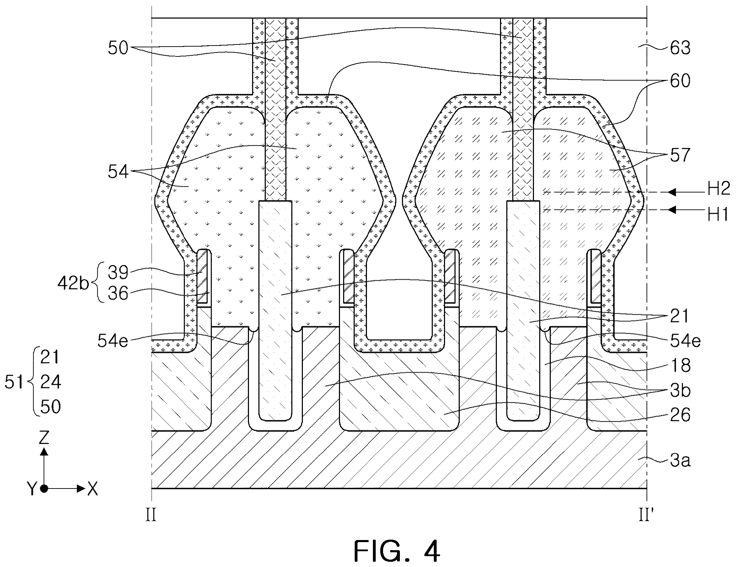

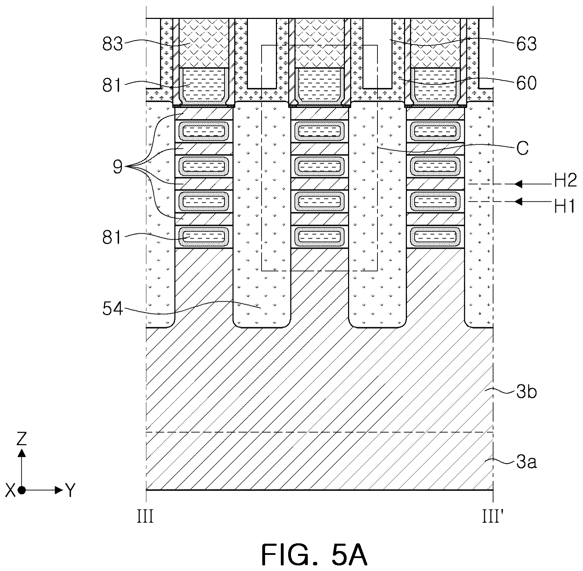

First, a semiconductor device according to one or more embodiments will be described with reference to FIGS. 1A, 1B, 2A, 2B, 3A, 3B, 4, 5A and 5B. In FIGS. 1A, 1B, 2A, 2B, 3A, 3B, 4, 5A and 5B, FIG. 1A is a plan view of a semiconductor device according to one or more embodiments on a first height level (H1) indicated by 'H1' in FIGS. 3A, 3B, 4, 5A and 5B, FIG. 1B is a partially enlarged view illustrating a region indicated by 'A1' in FIG. 1A, FIG. 2A is a plan view of a semiconductor device according to one or more embodiments on a second height level (H2) indicated by 'H2' in FIGS. 3A, 3B, 4, 5A and 5B, FIG. 2B is a partially enlarged view illustrating a region indicated by 'A2' in FIG. 2A, and FIG. 3A is a cross-sectional view illustrating a region taken along line I-I' of FIGS. 1A and 2A, FIG. 3B is a partially enlarged view illustrating a region indicated by 'B' in FIG. 3A, FIG. 4 is a cross-sectional view illustrating a region taken along line II-II' of FIG. 1A and FIG. 2A, FIG. 5A is a cross-sectional view illustrating a region taken along line III-III' of FIG. 1A and FIG. 2A, and FIG. 5B is a partially enlarged view illustrating a region indicated by 'C' of FIG. 5A.

Referring to FIGS. 1A, 1B, 2A, 2B, 3A, 3B, 4, 5A and 5B, a semiconductor device 1 according to one or more embodiments may include separation structures 51 and transistor structures T1, T2, T3 and T4. Each of the separation structures 51 may have a first side surface 51S1 and a second side surface 51S2 that are parallel to each other in a first horizontal direction (X-direction). Each of the separation structures 51 may have a line shape extending in a second horizontal direction (Y-direction), perpendicular to the first horizontal direction (X-direction).

The transistor structures T1, T2, T3 and T4 may include a first transistor structure T1, a second transistor structure T2, a third transistor structure T3, and a fourth transistor structure T4. The first transistor structure T1 and the second transistor structure T2 may face each other with one separation structure 51 interposed therebetween, and the third transistor structure T3 and the fourth transistor structure T4 may face each other with one separation structure 51 interposed therebetween. The first and second transistor structures T1 and T2 facing each other may have a mirror symmetrical structure, and the third and fourth transistor structures T3 and T4 facing each other may have a mirror symmetrical structure. The second and third transistor structures T2 and T3 may be disposed between a pair of adjacent separation structures 51.

Each of the first and second transistor structures T1 and T2 may include elements that may form a first transistor and elements contacting or adjacent to such elements, and each of the third and fourth transistor structures T3 and T4 may include elements that may form a second transistor and elements contacting or adjacent to such elements. Here, the first transistor may be an n-type metal oxide semiconductor (MOS) (NMOS) transistor or a p-type MOS (PMOS) transistor, and the second transistor may be a PMOS transistor when the first transistor is an NMOS transistor, and may be an NMOS transistor when the first transistor is a PMOS transistor.

Hereinafter, one separation structure 51 of the separation structures 51 and the first and second transistor structures T1 and T2 arranged on both sides of the separation structure 51 in a horizontal direction will be described.

The first transistor structure T1 may be disposed on the first side surface 51S1 of the separation structure 51, and the second transistor structure T2 may be disposed on the second side surface 51S2 of the separation structure 51.

Each of the transistor structures T1, T2, T3 and T4 may include channel layers 9, gate electrodes 81 and 82, a gate dielectric structure 79, and source/drain regions 54 and 57. The source/drain regions 54 of the first and second transistor structures T1 and T2 may have different conductivity types from the source/drain regions 57 of the third and fourth transistor structures T3 and T4.

The channel layers 9 may face the separation structure 51 in the first horizontal direction (X-direction).

In each of the first and second transistor structures T1 and T2, the gate electrode 81, the gate dielectric structure 79, the channel layers 9, and the source/drain regions 54 may form a first transistor.

In each of the third and fourth transistor structures T3 and T4, the gate electrode 82, the gate dielectric structure 79, the channel layers 9, and the source/drain regions 57 may form a second transistor.

The source/drain regions 54 and 57 may include an epitaxial semiconductor material layer formed by an epitaxial growth process.

The source/drain regions 54 of the first and second transistor structures T1 and T2 may have a first conductivity type, and the source/drain regions 57 of the third and fourth transistor structures T3 and T4 may have a second conductivity type. One of the first and second conductivity types may be an N-type conductivity type, and the other thereof may be a P-type conductivity type.

In one or more embodiments, when the source/drain regions 54 are source/drain regions having an N-type conductivity of an NMOS transistor, each of the source/drain regions 54 may include a silicon (Si) layer.

In one or more embodiments, when the source/drain regions 57 are source/drain regions having a P-type conductivity of a PMOS transistor, each of the source/drain regions 57 may include at least one of a silicon (Si) layer, a germanium (Ge) layer, or a silicon germanium (SiGe) layer.

Hereinafter, one separation structure 51 and the first and second transistor structures T1 and T2 disposed on both sides of the separation structure 51 in a horizontal direction will be described.

The source/drain regions 54 may include a first source/drain region 54a and a second source/drain region 54b spaced apart from each other and adjacent to each other in the second horizontal direction (Y-direction). The second horizontal direction (Y-direction) may be perpendicular to the first horizontal direction (X-direction).

The channel layers 9 may be disposed between the source/drain regions 54. Lower surfaces of the source/drain regions 54 may be disposed at a lower level than the channel layers 9.

Hereinafter, the channel layers 9 disposed between the first source/drain region 54a and the second source/drain region 54b among the channel layers 9 will be described.

The channel layers 9 may be stacked and spaced apart from each other in a vertical direction (Z-direction). The vertical direction (Z-direction) may be perpendicular to the first and second horizontal directions (X-direction and Y-direction). The channel layers 9 may be connected to the first source/drain region 54a and the second source/drain region 54b. Each of the channel layers 9 may have a first side surface 9S1 facing the separation structure 51 and a second side surface 9S2 opposing the first side surface 9S1. The channel layers 9 may be spaced apart from the separation structure 51. The channel layers 9 may include a lower channel layer 9L, a first intermediate channel layer 9M1 on the lower channel layer 9L, a second intermediate channel layer 9M2 on the first intermediate channel layer 9M1, and an upper channel layer 9U on the second intermediate channel layer 9M2. The channel layers 9 may be formed of a semiconductor material that may be used as a channel region of a transistor. For example, the channel layers 9 may include a semiconductor material such as single crystal silicon.

A distance between the channel layers 9 and the separation structure 51 may be about 1 nm to about 5 nm.

The gate electrode 81 may cover each of the channel layers 9. For example, the gate electrode 81 may cover an upper surface, a lower surface, and the second side surface 9S2 of each of the channel layers 9. The gate electrode 81 may include a lower electrode portion 81L, intermediate electrode portions 81M1, 81M2 and 81M3, and an upper electrode portion 81U. The lower electrode portion 81L may be disposed below a lower surface of the lower channel layer 9L. The intermediate electrode portions 81M1, 81M2 and 81M3 may be disposed between channel layers 9 adjacent to each other in the vertical direction (Z-direction), among the channel layers 9. For example, the intermediate electrode portions 81M1, 81M2 and 81M3 may include a first intermediate electrode portion 81M1 disposed between the lower channel layer 9L and the first intermediate channel layer 9M1, a second intermediate electrode portion 81M2 disposed between the first intermediate channel layer 9M1 and the second intermediate channel layer 9M2, and a third intermediate electrode portion 81M3 disposed between the second intermediate channel layer 9M2 and the upper channel layer 9U. The upper electrode portion 81U may be disposed on an upper surface of the upper channel layer 9U.

The gate electrode 81 may be formed of a conductive material. For example, the gate electrode 81 may include a first conductive material for controlling work function to control a threshold voltage of the transistor, and a second conductive material having low resistivity to lower resistance. For example, the gate electrode 81 may include a first conductive material that may include at least one of TiN, TaN, WN, NbN, TiAl, TiAlN, TiSi, TiSiN, TaSiN, or RuTiN, and a second conductive material that may include at least one of Ti, Ta, Ru, W, Mo, Pt, Ni, or Co.

A distance between the channel layers 9 and the separation structure 51 may be greater than a distance between the gate electrode 81 and the separation structure 51. For example, a distance between the first intermediate electrode portion 81M and the separation structure 51 may be smaller than a distance between the first intermediate channel layer 9M1 and the separation structure 51.

Each of the first, second, and third intermediate electrode portions 81M1, 81M2 and 81M3 may include a first electrode portion 81a disposed between the channel layers 9 adjacent to each other in the vertical direction (Z-direction) and a second electrode portion 81b extending from the first electrode portion 81a in a direction oriented toward the separation structure 51. In each of the first, second, and third intermediate electrode portions 81M1, 81M2 and 81M3, a thickness of the second electrode portion 81b in the vertical direction (Z-direction) may be greater than a thickness of the first electrode portion 81a in the vertical direction (Z-direction).

A distance between the gate electrode 81 of the first transistor structure T1 and the gate electrode 81 of the second transistor structure T2 may be smaller than a distance between the channel layers 9 of the first transistor structure T1 and the channel layers 9 of the second transistor structure T2. For example, a distance between the intermediate electrode portions 81M1, 81M2 and 81M3 of the gate electrode 81 of the first transistor structure T1 and the intermediate electrode portions 81M1, 81M2 and 81M3 of the gate electrode 81 of the second transistor structure T2 may be smaller than a distance between the upper channel layer 9U of the first transistor structure T1 and the upper channel layer 9U of the second transistor structure T2.

Each of the first and second transistor structures T1 and T2 may include gate spacers 42a and insulating spacers 45. The gate spacers 42a may include a first gate spacer 42a1 and a second gate spacer 42a2 disposed on both sides of the gate electrode 81 in a horizontal direction. Each of the gate spacers 42a may include a first spacer material layer 39 disposed on both sides of the gate electrode 81 in a horizontal direction and a second spacer material layer 36 disposed between the first spacer material layer 39 and the channel layers 9. The first spacer material layer 39 may include at least one of SiN, SiOCN, SiOC, SiBN, or SiCN, and the second spacer material layer 36 may include at least one of SiN, SiOCN, SiOC, SiBN, or SiCN. The second spacer material layer 36 may include a different material from the first spacer material layer 39.

The insulating spacers 45 may include a first insulating spacer 45a and a second insulating spacer 45b which are disposed between the first source/drain region 54a and the second source/drain region 54b, are adjacent to the separation structure 51, and are spaced apart from each other in the second horizontal direction (Y-direction). The first insulating spacer 45a may contact the first source/drain region 54a, and the second insulating spacer 45b may contact the second source/drain region 54b. The insulating spacers 45 may be spaced apart from the gate spacers 42a on a first level lower than that of the upper surface of the upper channel layer 9U among the channel layers 9. The insulating spacers 45 may contact the separation structure 51.

Each of the insulating spacers 45 may have a thickness of about 5 nm or less in the second horizontal direction (Y-direction).

Each of the insulating spacers 45 may have a thickness of about 0.5 nm to about 4 nm in the second horizontal direction (Y-direction).

The insulating spacers 45 may include a material other than silicon oxide. For example, the insulating spacers 45 may include at least one of SiN, SiOCN, SiOC, SiBN, or SiCN.

Each of the first and second transistor structures T1 and T2 may further include an insulating pattern 72. The insulating pattern 72 may include first portions 72a and second portions 72b extending from the first portions 72a. The first portions 72a of the insulating pattern 72 may be disposed between the channel layers 9 and the separation structure 51. The second portions 72b of the insulating pattern 72 may be disposed between the lower electrode portion 81L and the separation structure 51, between the intermediate electrode portions 81M1, 81M2 and 81M3 and the separation structure 51, and between the upper electrode portion 81U and the separation structure 51. In the insulating pattern 72, a thickness of each of the first portions 72a in the first horizontal direction (X-direction) may be greater than a thickness of each of the second portions 72b in the first horizontal direction (X-direction).

The thickness of each of the first portions 72a in the first horizontal direction (X-direction) may be about 1 nm to about 5 nm. The thickness of each of the second portions 72b in the first horizontal direction (X-direction) may be smaller than the thickness of each of the first portions 72a in the first horizontal direction (X-direction), and may be about 4 nm or less.

The thickness of each of the first portions 72a in the first horizontal direction (X-direction) may be greater than a thickness of the second gate dielectric layer 77.

In one or more embodiments, the thickness of each of the second portions 72b in the first horizontal direction (X-direction) may be smaller than the thickness of the second gate dielectric layer 77.

In one or more embodiments, the thickness of each of the second portions 72b in the first horizontal direction (X-direction) may be the same or substantially the same (e.g., permitting minor variations) as the thickness of the second gate dielectric layer 77.

Each of the first portions 72a may have a concave upper surface and a concave lower surface. When viewed in plan, each of the first portions 72a may have concave side surfaces in the second horizontal direction (Y-direction). The insulating pattern 72 may contact the channel layers 9 and the separation structure 51 between the channel layers 9 and the separation structure 51.

A width of the insulating pattern 72 in the second horizontal direction (Y-direction) may be smaller than a width of each of the channel layers 9 in the second horizontal direction (Y-direction). The width of the insulating pattern 72 in the first horizontal direction (X-direction) may be smaller than the width of each of the channel layers 9 in the first horizontal direction (X-direction).

The width of the insulating pattern 72 in the second horizontal direction (Y-direction) may be greater than a width of each of the insulating spacers 45 in the second horizontal direction (Y-direction).

The insulating pattern 72 may include a different material from the insulating spacers 45. For example, the insulating pattern 72 may include silicon oxide.

The gate dielectric structure 79 may be disposed between the gate spacers 42a and the gate electrode 81, between the channel layers 9 and the gate electrode 81, between the source/drain regions 54 and the gate electrode 81, between the insulating pattern 72 and the gate electrode 81, and between the separation structure 51 and the gate electrode 81.

The gate dielectric structure 79 may include a first gate dielectric layer 75 and a second gate dielectric layer 77.

The second gate dielectric layer 77 may be disposed between the gate spacers 42a and the gate electrode 81, between the channel layers 9 and the gate electrode 81, between the source/drain regions 54 and the gate electrode 81, between the insulating pattern 72 and the gate electrode 81, and between the separation structure 51 and the gate electrode 81. The second gate dielectric layer 77 may contact the gate electrode 81.

The first gate dielectric layer 75 may be disposed between the second gate dielectric layer 77 and the channel layers 9, and between the second gate dielectric layer 77 and the source/drain regions 54. The first gate dielectric layer 75 may include a first dielectric portion 75a disposed between the second gate dielectric layer 77 and the channel layers 9, and a second dielectric portion 75b disposed between the second gate dielectric layer 77 and the source/drain regions 54. A thickness of the second dielectric portion 75b may be greater than a thickness of the first dielectric portion 75a. Accordingly, by forming the thickness of the second dielectric portion 75b to be greater than the thickness of the first dielectric portion 75a, a separation distance between the gate electrode 81 and the source/drain regions 54 may be increased, so that leakage current of a transistor caused by a Gate-Induced Drain Leakage (GIDL) phenomenon may be prevented or minimized.

The separation structure 51 may include a first separation pattern 21, a second separation pattern 24, and a third separation pattern 50.

The first separation pattern 21 may include a nitride series material. The first separation pattern 21 may be formed of a dielectric having a dielectric constant of about 7 or less. For example, the first separation pattern 21 may include SiN, SiOCN, SiBN, or SiCN.

The second separation pattern 24 may include a nitride series material. For example, the second separation pattern 24 may include SiN, SiOCN, SiBN, or SiCN. In one or more embodiments, the second separation pattern 24 may include the same material as the first separation pattern 21. In one or more embodiments, the second separation pattern 24 may include a different material from the first separation pattern 21.

The third separation pattern 50 may include a nitride-based material. For example, the third separation pattern 50 may include SiN, SiOCN, SiBN, or SiCN. In one or more embodiments, the third separation pattern 50 may include the same material as the first separation pattern 21. In one or more embodiments, the third separation pattern 50 may include a different material from the first separation pattern 21.

The separation structure 51 may include a first separation region 51a adjacent to the gate electrode 81, the gate dielectric structure 79 and the channel layers 9, and a second separation region 51b adjacent to the first and second source/drain regions 54a and 54b. For example, in the separation structure 51, a region disposed between the gate electrode 81 of the first transistor structure T1 and the gate electrode 81 of the second transistor structure T2 may be defined as the first separation region 51a, and a region disposed between the source/drain regions 54 of the first transistor structure T1 and the source/drain regions 54 of the second transistor structure T2 may be defined as the second separation region 51b.

The first separation pattern 21 may be disposed in the first separation region 51a and the second separation region 51b. The first separation pattern 21 may have an upper surface disposed at a higher level than that of the upper channel layer 9U among the channel layers 9 in the first separation region 51a, and may have an upper surface disposed at a lower level than that of the upper channel layer 9U in the second separation region 51b. A ( of the first separation pattern 21 may be disposed at a lower level than that of lower surfaces of the source/drain regions 54.

The second separation pattern 24 may be disposed in the first separation region 51a. The second separation pattern 24 may be disposed on the first separation pattern 21 in the first separation region 51a. A width of the first horizontal direction (X-direction) of the second separation pattern 24 may be greater than a width of the first horizontal direction (X-direction) of the first separation pattern 21. The second separation pattern 24 may cover an upper surface of the first separation pattern 21 and may cover a portion of an upper side surface of the first separation pattern 21. A portion of the second separation pattern 24 may overlap the insulating pattern 72. An upper surface of the second separation pattern 24 may be coplanar with an upper surface of the gate electrode 81.

A side surface of the second separation pattern 24 may have a bent portion 24B. The bent portion 24B on the side surface of the second separation pattern 24 may be disposed between a first side surface that extends from the upper surface of the second separation pattern 24 is substantially vertical, and a second side surface extending and inclined from the first side surface to the first separation pattern 21.

A height level difference between the bent portion 24B on the side surface of the second separation pattern 24 and the upper surface of the upper channel layer 9U may be about 5 nm to about 10 nm.

The height level difference between the bent portion 24B on the side surface of the second separation pattern 24 and the upper surface of the upper channel layer 9U may be greater than a thickness of the gate dielectric structure 79.

The height level difference between the bent portion 24B on the side surface of the second separation pattern 24 and the upper surface of the upper channel layer 9U may be greater than a distance between the channel layers 9 and the separation structure 51.

The third separation pattern 50 may be disposed in the second separation region 51b. The third separation pattern 50 may contact the first separation pattern 21 within the second separation region 51b. Within the second separation region 51b, the upper surface of the first separation pattern 21 may be disposed at a lower level than that of upper surfaces of the source/drain regions 54, and an upper surface of the third separation pattern 50 may be disposed at a higher level than that of the upper surfaces of the source/drain regions 54.

The semiconductor device 1 may further include a base 3a, protrusion portions 3b extending upwardly from the base 3a, and an element isolation insulating pattern 26 disposed on the base 3a and disposed between the protrusion portions 3b.

In one or more embodiments, the base 3a and the protrusion portions 3b may include a semiconductor material.

In one or more embodiments, the base 3a and the protrusion portions 3b may include an insulating material.

The element isolation insulating pattern 26 may include an insulating material such as silicon oxide.

The channel layers 9 may be disposed on the protrusion portions 3b and may be spaced apart from the protrusion portions 3b.

When viewed from one of the protrusion portions 3b disposed below the first transistor structure T1 among the protrusion portions 3b, the lower electrode portion 81L of the gate electrode 81 may be disposed between the lower channel layer 9L and the protrusion portion 3b, and the gate dielectric structure 79 may cover an upper surface and a side surface of the protrusion portion 3b.

A lower region of the separation structure 51 may be disposed on the base 3a, and may be disposed between the protrusion portions 3b adjacent to each other in the first horizontal direction (X-direction), among the protrusion portions 3b.

In the protrusion portions 3b, upper surfaces of the protrusion portions 3b disposed below the channel layers 9 may be disposed at a higher level than that of upper surfaces of the protrusion portions 3b disposed below the source/drain regions 54.

Each of the source/drain regions 54 may include a portion contacting an upper surface of the protrusion portion 3b and an extension portion 54e contacting the separation structure 51 and extending between the protrusion portion 3b and the separation structure 51.

A height level difference between a lower end of the extension portion 54e of each of the source/drain regions 54 and the upper surface of the protrusion portion 3b may be about 5 nm or less.

The upper surface of the protrusion portion 3b disposed below the channel layers 9 and the gate electrode 81 may be disposed at a higher level than that of an upper surface of the element isolation insulating pattern 26 disposed below the gate electrode 81.

The source/drain region 54 may include a portion overlapping the protrusion portion 3b and a portion overlapping the element isolation insulating pattern 26. The upper surface of the element isolation insulating pattern 26 overlapping the source/drain region 54 and disposed below the source/drain region 54 may be disposed at a higher level than that of the upper surface of the protrusion portion 3b disposed below the source/drain region 54. The element isolation insulating pattern 26 may include silicon oxide.

The semiconductor device 1 may further include a residual spacer 42b disposed between the upper surface of the element isolation insulating pattern 26 disposed below the source/drain region 54 and the source/drain region 54. The residual spacer 42b may include the same material as the gate spacer 42a. The residual spacer 42b may include a first spacer material layer 39 and a second spacer material layer 36 disposed between a side surface of the first spacer material layer 39 and the source/drain region 54, and between a lower surface of the first spacer material layer 39 and the upper surface of the element isolation insulating pattern 26.

The semiconductor device 1 may further include an insulating liner 18 covering both side surfaces of the separation structure 51 in a horizontal direction. The insulating liner 18 may cover both side surfaces in a horizontal direction of the separation structure 51 and may extend to cover a lower surface of the separation structure 51. The insulating liner 18 may be disposed between the protrusion portions 3b and the separation structure 51, and between the separation structure 51 and the base 3a. The insulating liner 18 may be disposed below the insulating pattern 72.

The insulating liner 18 may include an oxide. For example, the insulating liner 18 may include silicon oxide.

In one or more embodiments, the insulating pattern 72 may extend from the insulating liner 18.

In one or more embodiments, an upper surface 18S of the insulating liner 18 contacting the insulating pattern 72 may be formed at a lower level than that of the upper surface of the protrusion portion 3b.

In one or more embodiments, when the insulating pattern 72 and the insulating liner 18 are formed of the same material, a boundary between the insulating pattern 72 and the insulating liner 18 may be unclear. For example, the insulating pattern 72 and the insulating liner 18 may be formed of the same material, for example, silicon oxide.

The semiconductor device 1 may further include an etch stop layer 60 and an interlayer insulating layer 63. The etch stop layer 60 may be disposed on the element isolation insulating pattern 26, the source/drain regions 54, an upper side surface of the separation structure 51, and side surfaces of the gate spacers 42a. The etch stop layer 60 may include SiN, SiCN, SiBN, or SiOCN. The interlayer insulating layer 63 may include at least one of silicon oxide or a low-κ dielectric. The low-x dielectric may be a dielectric having a dielectric constant lower than that of silicon oxide.

The semiconductor device 1 may further include a gate capping pattern 84 disposed on the gate electrodes 81 and the separation structure 51 between the gate electrodes 81. The gate capping pattern 84 may include a nitride-based insulating material.

The semiconductor device 1 may further include a gate separation pattern 86 which penetrates through the gate capping pattern 84, passes between the gate electrode 81 of the second transistor structure T2 and the gate electrode 82 of the third transistor structure T3 and penetrates through the gate dielectric structure 79, and extends into the element isolation insulating pattern 26. The gate separation pattern 86 may include a nitride-based insulating material.

In one or more embodiments, the insulating spacers 45 may prevent leakage current from occurring between the source/drain regions 54 adjacent to each other in the second horizontal direction (Y-direction) and adjacent to the separation structure 51.

In one or more embodiments, the insulating spacers 45 may prevent bridge failures in which the source/drain regions 54 adjacent to each other in the second horizontal direction (Y-direction) and adjacent to the separation structure 51 are connected to each other.

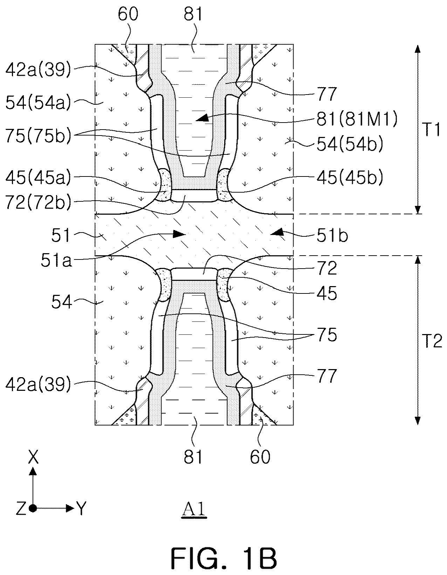

In one or more embodiments, the insulating spacers 45 may prevent leakage current from occurring between an edge of the gate electrode 81 adjacent to the separation structure 51 and the source/drain regions 54, as in the plan view in FIG. 1B.

In one or more embodiments, a distance between the gate electrode 81 and the separation structure 51 may be smaller than a distance between the channel layers 9 and the separation structure 51. Accordingly, since a region in which the gate electrode 81 and the channel layers 9 face each other may be increased, the gate control ability of the transistor including the gate electrode 81 and the channel layers 9 may be increased.

Next, various modified example embodiments of the elements of the above-described embodiments will be described. The various modified examples of the elements described below will be described with a focus on the modified or replaced elements. Description of aspects that are the same as or similar to those described above may be omitted. In addition, the elements that may be modified or replaced as described below are described with reference to the drawings below, but the elements that may be modified or replaced may be combined with each other or with the elements described above to form the semiconductor device 1 according to one or more embodiments.

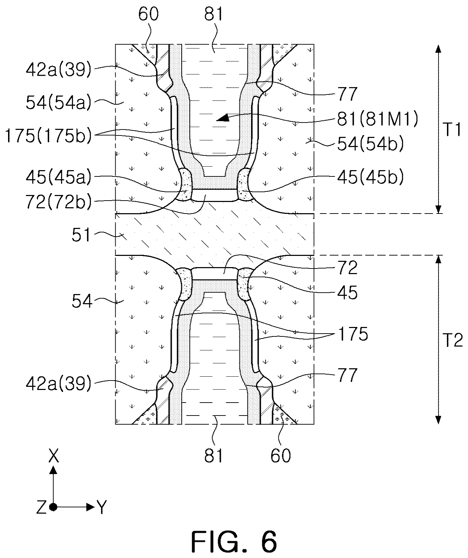

FIG. 6 is an enlarged plan view illustrating a modified example of the second dielectric portion 75b in FIG. 1B described above.

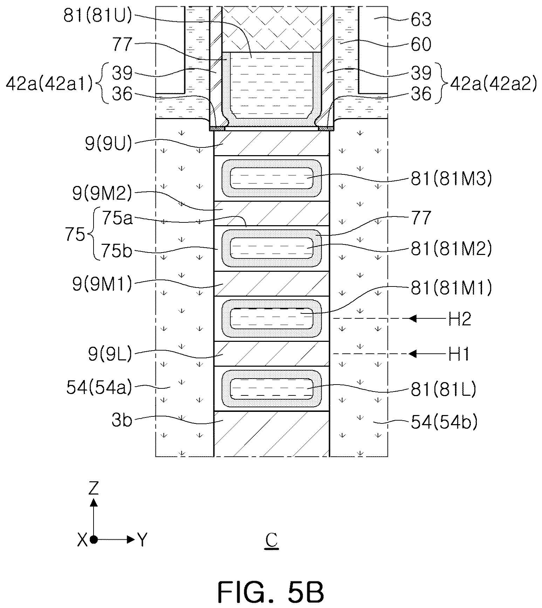

In one or more embodiments, referring to FIG. 6, the second dielectric portion (75b in FIG. 1B and FIG. 5B) described above may be replaced with a second dielectric portion 175b having a reduced thickness, as in FIG. 6. Accordingly, a gate dielectric structure 79 (see FIGS. 1A, 1B, 3A, 3B, 5A and 5B) described above may be replaced with a gate dielectric structure 179 including the second dielectric portion 175b having a reduced thickness.

The second dielectric portion 175b may have a thickness smaller than that of the second gate dielectric layer 77.

The second dielectric portion 175b may have a thickness smaller than that of the second portion 72b of the insulating pattern 72.

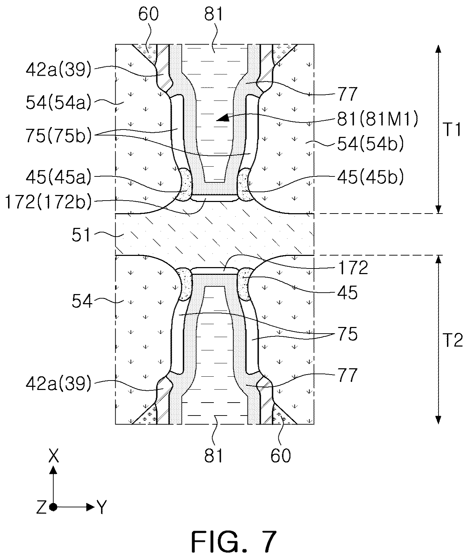

FIG. 7 is an enlarged plan view illustrating a modified example of the second portion 72b of the insulating pattern 72 in FIG. 1B described above.

In one or more embodiments, referring to FIG. 7, the second portion 72b (see FIG. 1B) described above may be replaced with a second portion 172b having a reduced thickness as in FIG. 7. Accordingly, the insulating pattern 72 (see FIGS. 1A, 1B, 2A, 2B, FIG. 3A and 3B) described above may be replaced with an insulating pattern 172 including the second portion 172b having a reduced thickness.

The second portion 172b may have a thickness smaller than a thickness of the second gate dielectric layer 77.

The second portion 172b may have a thickness smaller than a thickness of the second dielectric portion 75b.

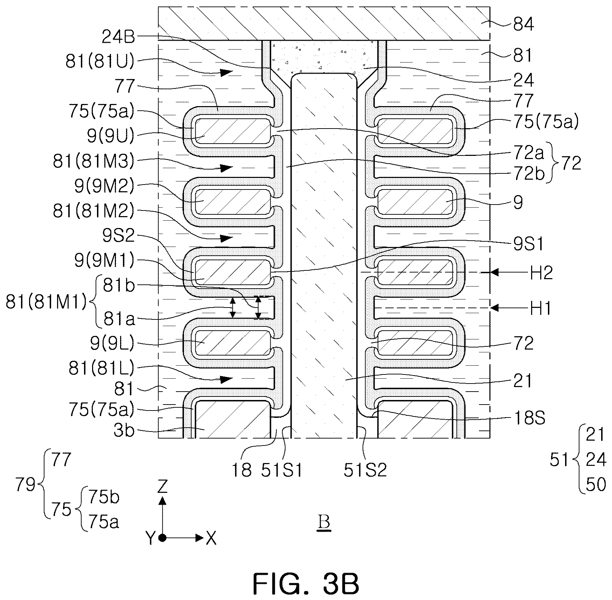

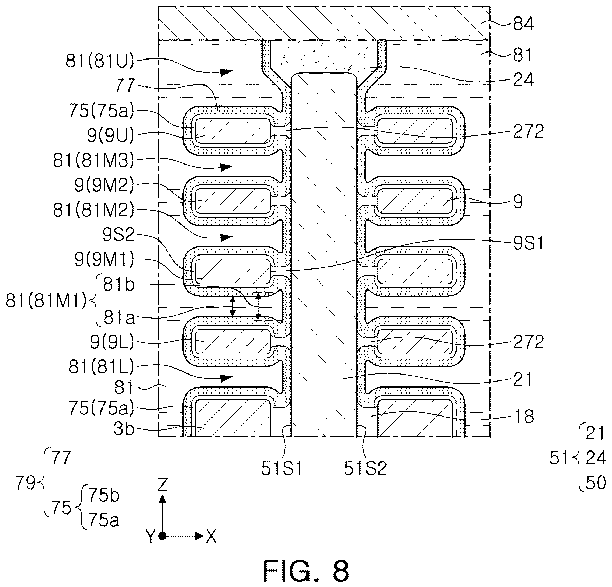

FIG. 8 is an enlarged cross-sectional view for explaining a modified example of the insulating pattern 72 in FIG. 3B described above.

In one or more embodiments, referring to FIG. 8, the insulating pattern 72 (see FIGS. 3A and 3B) may be replaced with insulating patterns 272 spaced apart from each other in the vertical direction (Z-direction). The insulating patterns 272 may be disposed between the channel layers 9 and the separation structure 51. The gate dielectric structure 79 may contact the separation structure 51. For example, the second gate dielectric layer 77 of the gate dielectric structure 79 may contact the first separation pattern 21 of the separation structure 51.

A thickness of each of the insulating patterns 272 in the vertical direction (Z-direction) may be smaller than a thickness of each of the channel layers 9 in the vertical direction (Z-direction).

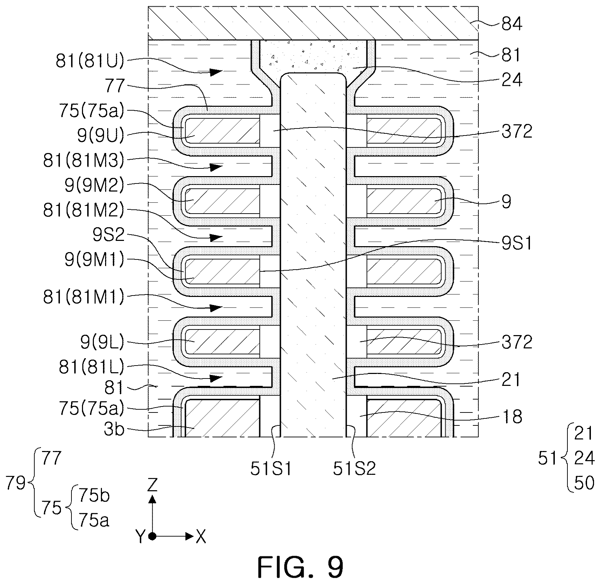

FIG. 9 is an enlarged cross-sectional view illustrating a modified example of the insulating pattern 272 in FIG. 8 described above.

In one or more embodiments, referring to FIG. 9, the insulating pattern 272 (see FIG. 8) may be replaced with insulating patterns 372 as in FIG. 9. Each of the insulating patterns 372 may have a thickness equal to or greater than the thickness of each of the channel layers 9.

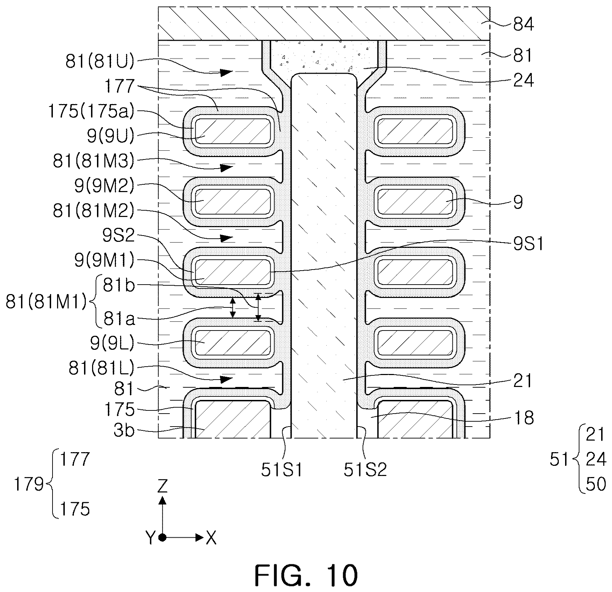

FIG. 10 is an enlarged cross-sectional view illustrating a modified example of the gate dielectric structure 79 in FIG. 3B described above.

In one or more embodiments, referring to FIG. 10, the gate dielectric structure 79 (see FIG. 3B) described above may be replaced with the gate dielectric structure 179 surrounding each of the channel layers 9. For example, the gate dielectric structure 179 may cover the first and second side surfaces 9S1 and 9S2 of each of the channel layers 9 facing each other in the first horizontal direction (X-direction), an upper surface of each of the channel layers 9, and a lower surface of each of the channel layers 9. Accordingly, the gate dielectric structure 179 may be disposed between the channel layers 9 and the separation structure 51. The insulating pattern 72 described in FIG. 3B may be omitted.

The second gate dielectric layer 77 (see FIG. 3B) described above may be replaced with a second gate dielectric layer 177 surrounding each of the channel layers 9 in the first horizontal direction (X-direction), and the first gate dielectric layer 75 (see FIG. 3B) described above may be replaced with a first gate dielectric layer 175 disposed between the channel layers 9 and the second gate dielectric layer 177. The gate dielectric structure 179 may include the first gate dielectric layer 175 and the second gate dielectric layer 177.

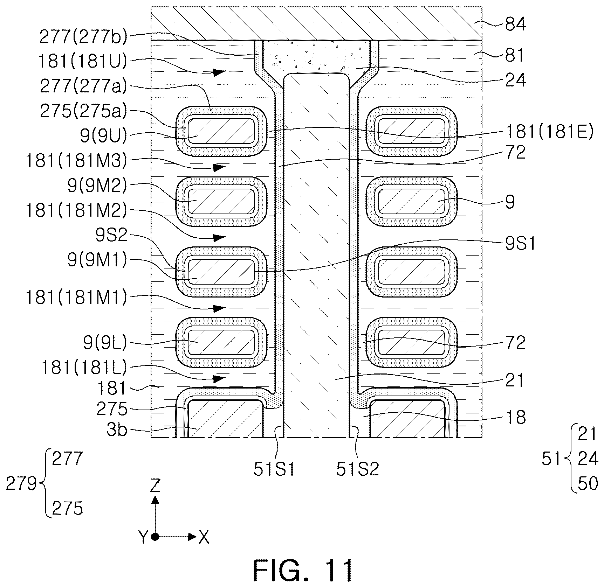

FIG. 11 is an enlarged cross-sectional view illustrating a modified example of the gate dielectric structure 179 in FIG. 10 described above and the gate electrode 81 described above.

In one or more embodiments, referring to FIG. 11, the second gate dielectric layer 177 (see FIG. 10) described above may be replaced with a second gate dielectric layer 277 including first dielectric portions 277a respectively surrounding the channel layers 9 in the first horizontal direction (X-direction) and a second dielectric portion 277b spaced apart from the first dielectric portions 277a and contacting the separation structure 51. The first gate dielectric layer 175 (see FIG. 10) described above may be replaced with a first gate dielectric layer 275 disposed between the first dielectric portions 277a and the channel layers 9. Accordingly, the gate dielectric structure 179 (see FIG. 10) described above may be replaced with a gate dielectric structure 279 including the first and second gate dielectric layers 275 and 277.

The gate electrode 81 (see FIG. 10) described above may be replaced with a gate electrode 181 including extension portions 181E extending between the first dielectric portions 277a and the second dielectric portions 277b. The gate electrode 181 may include, as described above, a lower electrode portion 181L disposed below the lower surface of the lower channel layer 9L, intermediate electrode portions 181M1, 181M2 and 181M3 disposed between channel layers 9 adjacent to each other in the vertical direction (Z-direction), among the channel layers 9, and an upper electrode portion 181U disposed on the upper surface of the upper channel layer 9U. The extension portions 181E of the gate electrode 181 may extend from the lower electrode portion 181L, the intermediate electrode portions 181M1, 181M2 and 181M3 and the upper electrode portion 181U to a space between the second dielectric portion 277b and the first dielectric portions 277a.

Since the gate electrode 181 may surround each of the channel layers 9 in the first horizontal direction (X-direction), the gate control ability of the transistor including the gate electrode 181 and the channel layers 9 may be increased.

Next, examples of an interconnection structure electrically connected to elements of the transistor will be described with reference to FIGS. 12, 13, 14, 15, and 16.

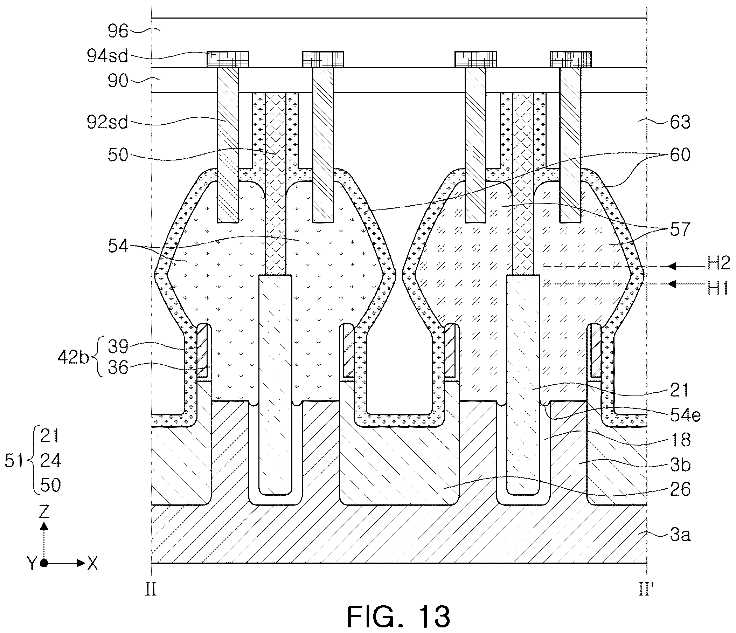

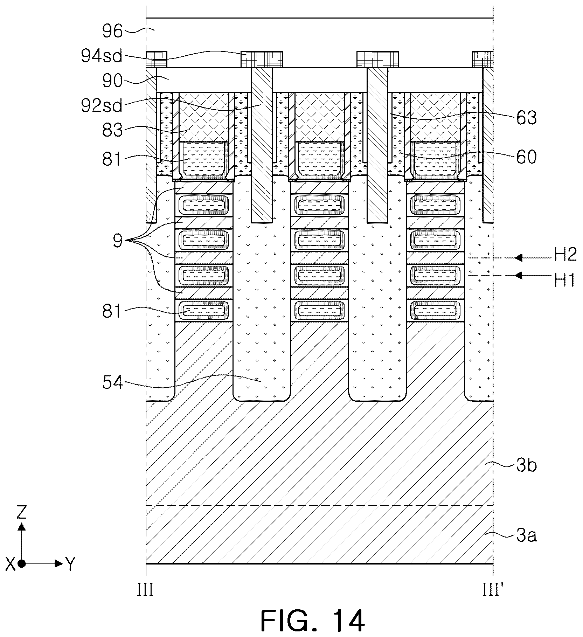

FIGS. 12, 13 and 14 are cross-sectional views illustrating a semiconductor device according to one or more embodiments. Referring to FIGS. 12, 13 and 14, an interconnection structure electrically connected to the gate electrodes 81 and 82 and the source/drain regions 54 and 57 described above will be described. FIG. 12 is a cross-sectional view illustrating an interconnection structure in which the insulating pattern 72 in FIG. 3A is replaced with the insulating pattern 172 described in FIG. 7, and which is electrically connected to the gate electrodes 81 and 82, in the cross-sectional structure of FIG. 3A, FIG. 13 is a cross-sectional view illustrating an interconnection structure electrically connected to the source/drain regions 54 and 57 in the cross-sectional structure of FIG. 4, and FIG. 14 is a cross-sectional view illustrating an interconnection structure electrically connected to the source/drain regions 54 and 57 in the cross-sectional structure of FIG. 5.

In one or more embodiments, referring to FIGS. 12, 13 and 14, an upper insulating layer 90 may be disposed on the gate capping pattern 84 and the interlayer insulating layer 63. Gate contact plugs 92g penetrating through the upper insulating layer 90 and the gate capping pattern 84 and connected to the gate electrodes 81 and 82 may be disposed. Front source/drain contact plugs 92sd penetrating through the upper insulating layer 90, the interlayer insulating layer 63 and the etch stop layer 60 and connected to the source/drain regions 54 and 57 may be disposed.

Gate connection interconnection lines 94g connected to the gate contact plugs 92g and front source/drain connection interconnection lines 94sd connected to the front source/drain contact plugs 92sd may be disposed on the upper insulating layer 90.

An upper capping insulating structure 96 covering the gate connection interconnection lines 94g and the front source/drain connection interconnection lines 94sd may be disposed on the upper insulating layer 90.

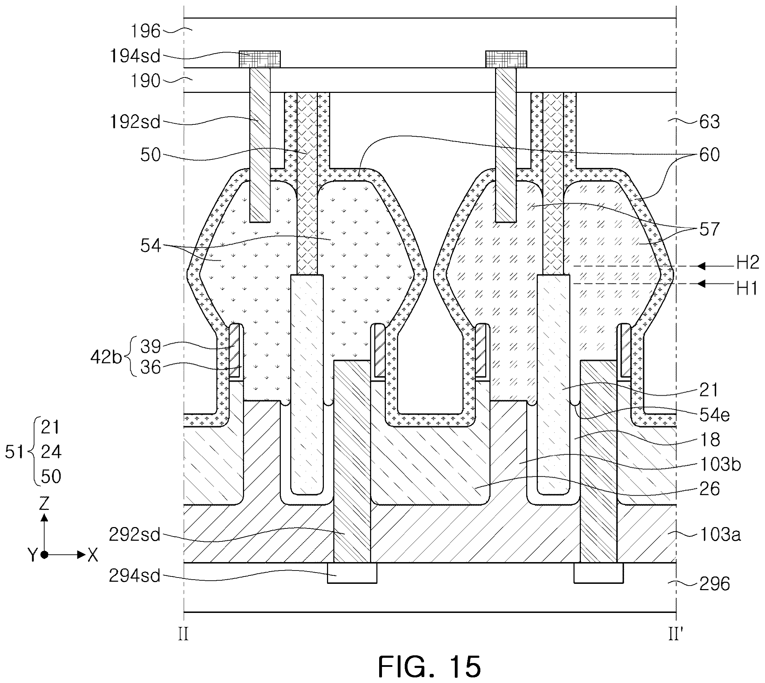

Referring to FIG. 15, an interconnection structure electrically connected to the source/drain regions 54 and 57 described above will be described. FIG. 15 is a cross-sectional view illustrating an interconnection structure electrically connected to the source/drain regions 54 and 57 in the cross-sectional structure of FIG. 4.

In one or more embodiments, referring to FIG. 15, the base 3a and the protrusion portions 3b described above may be a base 103a and protrusion portions 103b including an insulating material.

An upper insulating layer 190 may be disposed on the interlayer insulating layer 63. Front source/drain contact plugs 192sd penetrating through the upper insulating layer 190, the interlayer insulating layer 63, and the etch stop layer 60 and connected to some of the source/drain regions 54 and 57, and rear source/drain contact plugs 292sd penetrating through the base 103a and the protrusion portions 103b and connected to the others of the source/drain regions 54 and 57 may be disposed.

Front source/drain connection interconnection lines 194sd connected to the front source/drain contact plugs 192sd may be disposed on the upper insulating layer 190.

An upper capping insulating structure 196 covering the front source/drain connection interconnection lines 194sd may be disposed on the upper insulating layer 190.

Rear source/drain connection interconnection lines 294sd connected to the rear source/drain contact plugs 292sd may be disposed below the base 103a.

A rear capping insulating structure 296 covering the rear source/drain connection interconnection lines 294sd may be disposed below the base 103a.

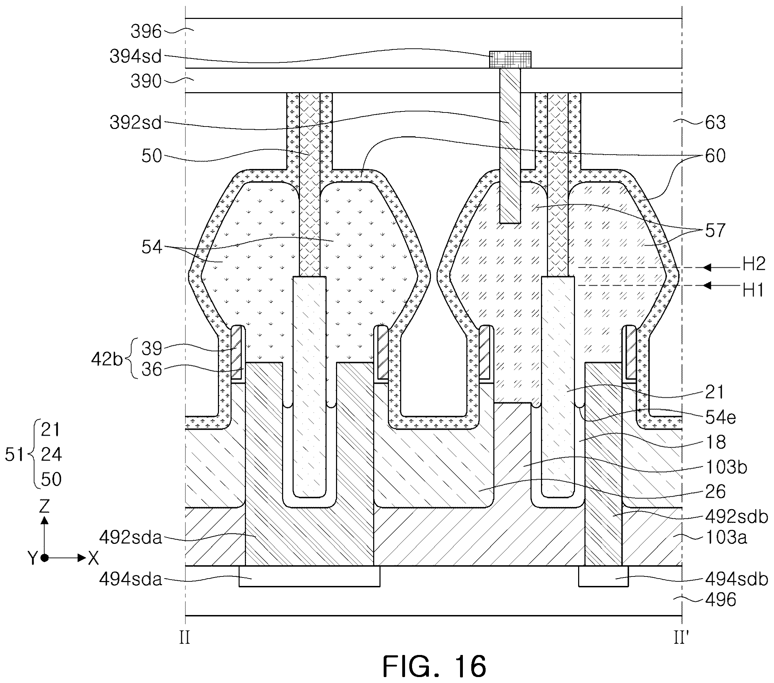

Referring to FIG. 16, an interconnection structure electrically connected to the source/drain regions 54 and 57 described above will be described. FIG. 16 is a cross-sectional view illustrating an interconnection structure electrically connected to the source/drain regions 54 and 57 in the cross-sectional structure of FIG. 4.

In one or more embodiments, with reference to FIG. 16, the base 3a and the protrusion portions 3b described above may be a base 103a and protrusion portions 103b including an insulating material.

An upper insulating layer 390 may be disposed on the interlayer insulating layer 63.

A front source/drain contact plug 392sd penetrating through the upper insulating layer 390, the interlayer insulating layer 63 and the etch stop layer 60 and connected to some of the source/drain regions 57, and a first rear source/drain contact plug 492sdb penetrating through the base 103a and the protrusion portions 103b and connected to the others of the source/drain regions 57 may be disposed.

A second rear source/drain contact plug 492sda penetrating through the base 103a and the protrusion portions 103b and simultaneously connected to the source/drain regions 54 disposed on both sides of the first separation pattern 21 in a horizontal direction may be disposed.

A front source/drain connection interconnection line 394sd connected to the front source/drain contact plug 392sd may be disposed on the upper insulating layer 390.

An upper capping insulating structure 396 covering the front source/drain connection interconnection line 394sd may be disposed on the upper insulating layer 390.

A first rear source/drain connection interconnection line 494sdb connected to the first rear source/drain contact plug 492sdb, and a second rear source/drain connection interconnection line 494sda connected to the second rear source/drain contact plug 492sda may be disposed below the base 103a.

A rear capping insulating structure 496 covering the first rear source/drain connection interconnection line 494sdb and the second rear source/drain connection interconnection line 494sda may be disposed below the base 103a.

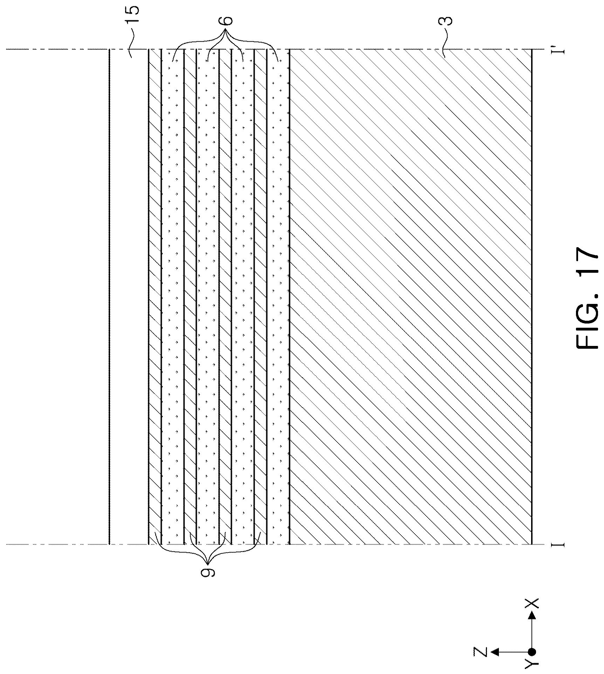

FIGS. 17, 18, 19, 20, 21, 22, 23, 24A, 24B, 24C, 25, 26A, 26B, 26C, 27A, 27B, 28, 29, 30, 31A, 31B, 31C, 32A, 32B, 33A, 33B, 34 and 35 are diagrams illustrating a method of manufacturing a semiconductor device according to one or more embodiments.

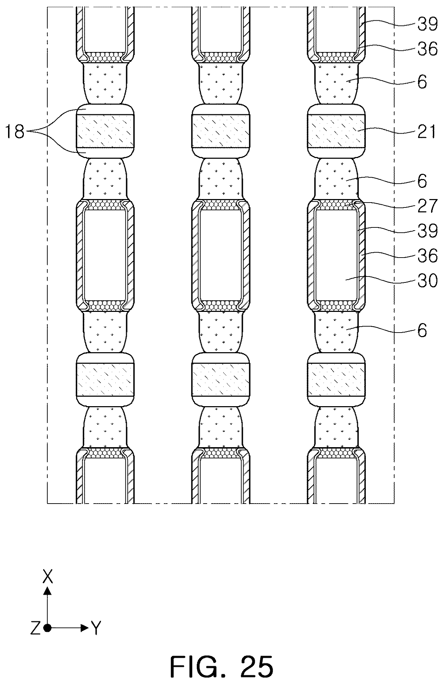

FIGS. 17 to 23, 24A, 26A, 31A, 32A, 34 and 35 are cross-sectional views illustrating a region taken along line I-I' of FIGS. 1A and 2B, FIGS. 24B, 26B, 27A, 29, 31B, 32B and 33A are cross-sectional views illustrating a region taken along line II-II' of FIGS. 1A and 2A, FIGS. 24C, 26C, 27B, 31C and 33B are cross-sectional views illustrating a region taken along line III-III' of FIGS. 1A and 2A, FIGS. 25, 28 and 30 are plan views illustrating a method of manufacturing a semiconductor device according to one or more embodiments. FIGS. 25, 28 and 30 are plan views on the second height level (H2) indicated as 'H2' in FIGS. 3A, 3B, 4, 5A and 5B described above.

Referring to FIG. 17, sacrificial layers 6 and channel layers 9 on a substrate 3 may be formed and alternately stacked. A lowermost layer, among the sacrificial layers 6 and the channel layers 9, may be a lowermost sacrificial layer 6, and an uppermost layer may be an uppermost channel layer 9. The substrate 3 may be a semiconductor substrate. For example, the substrate 3 may be a single-crystal silicon substrate.

The channel layers 9 may be single-crystal silicon (Si) layers formed by an epitaxial growth process. The sacrificial layers 6 may be single-crystal silicon germanium (SiGe) layers formed by an epitaxial growth process.

A capping layer 15 may be formed on the sacrificial layers 6 and the channel layers 9. The capping layer 15 may be formed of a material different from a material of the sacrificial layers 6 and a material of the channel layers 9.

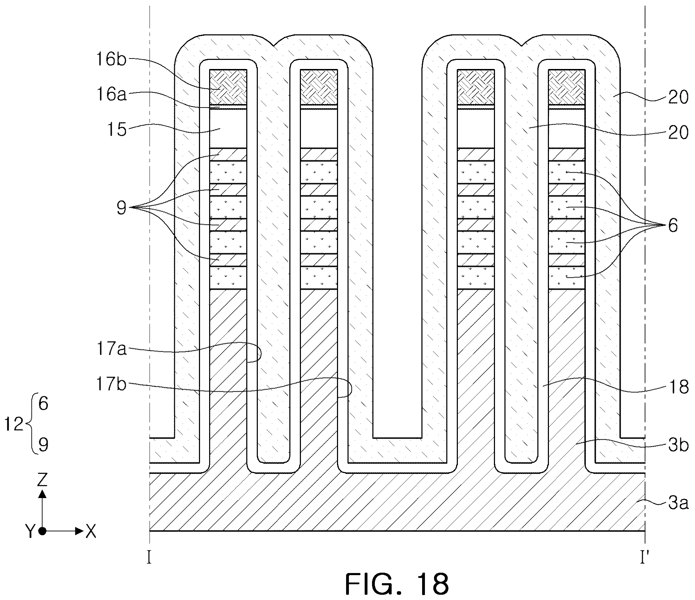

Referring to FIG. 18, mask patterns 16a and 16b including a first mask layer 16a and a second mask layer 16b sequentially stacked on the capping layer 15 may be formed. An etching process using the mask patterns 16a and 16b as an etching mask may be performed to form trenches 17a and 17b penetrating through the sacrificial layers 6 and the channel layers 9 and extending into the substrate 3. By the trenches 17a and 17b, the substrate 3 may be formed of a base 3a and protrusion portions 3b protruding from the base 3a, and the sacrificial layers 6 and the channel layers 9 remaining on the protrusion portions 3b may form stack patterns 12. Each of the stack patterns 12 may include the sacrificial layers 6 and the channel layers 9. The trenches 17a and 17b may include first trenches 17a and second trenches 17b alternately arranged in the first horizontal direction (X-direction). Each of the trenches 17a and 17b may extend in the second horizontal direction (Y-direction), perpendicular to the first horizontal direction (X-direction). In the first horizontal direction (X-direction), each of the first trenches 17a may have a width smaller than that of each of the second trenches 17b.

An insulating liner 18 conformally covering internal walls of the trenches 17a and 17b and covering the mask patterns 16a and 16b may be formed. The insulating liner 18 may be formed of silicon oxide.

A first separation insulating layer 20 may be formed on the insulating liner 18. The first separation insulating layer 20 may fill the first trenches 17a on the insulating liner 18 and conformally cover the second trenches 17b. The first separation insulating layer 20 may be formed of SiN, SiOCN, SiBN, or SiCN.

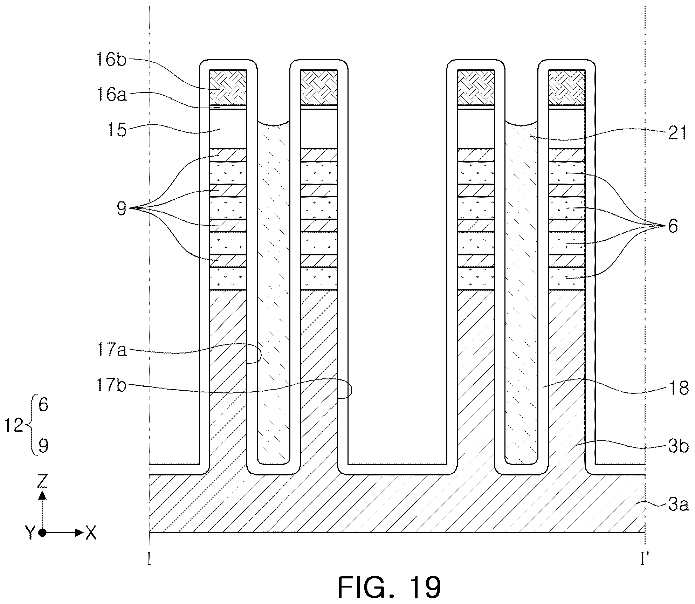

Referring to FIG. 19, the first separation insulating layer 20 may be isotropically etched to form first separation patterns 21 remaining within the first trenches 17a. Upper surfaces of the first separation patterns 21 may be formed at a higher level than that of an uppermost channel layer among the channel layers 9.

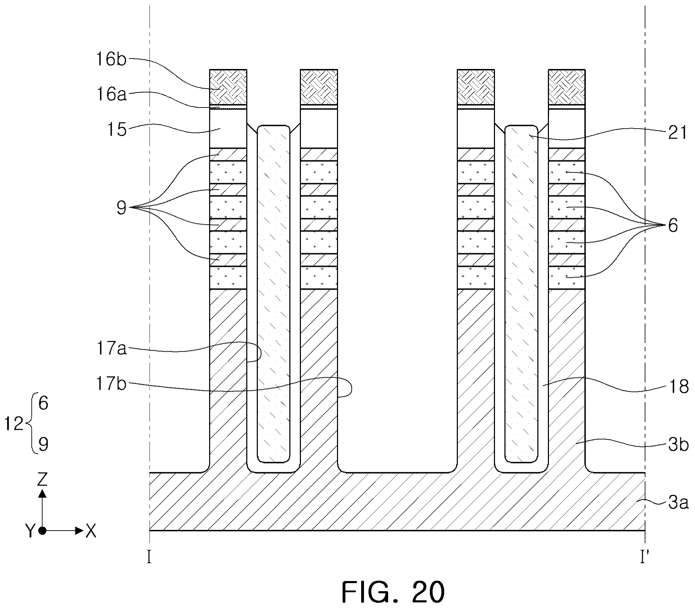

Referring to FIG. 20, the insulating liner 18 may be isotropically etched. By the isotropic etching, the insulating liner 18 disposed within the second trenches 17b and the insulating liner 18 disposed on the mask patterns 16a and 16b may be removed. The insulating liner 18 may remain to cover side surfaces and lower surfaces of the first separation patterns 21.

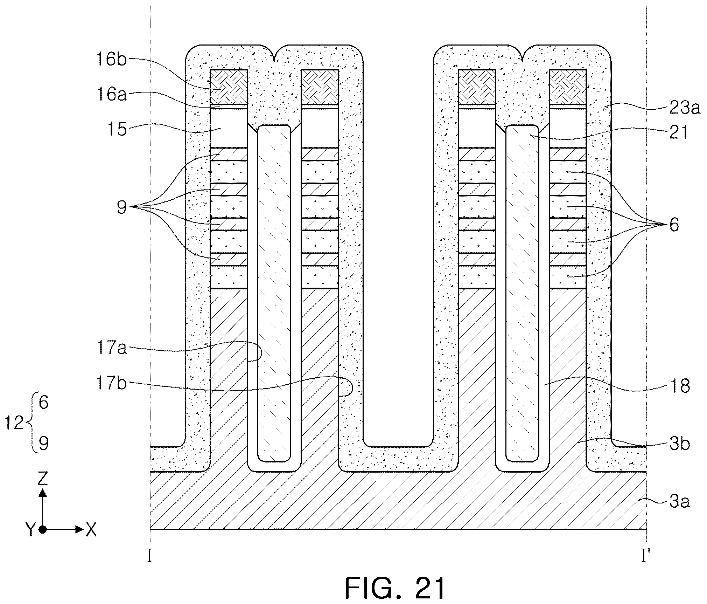

Referring to FIG. 21, a second separation insulating layer 23a covering the upper surfaces of the first separation patterns 21 and the insulating liner 18 and conformally covers internal walls of the second trenches 17b may be formed. The second separation insulating layer 23a may be formed of SiN, SiOCN, SiBN, or SiCN.

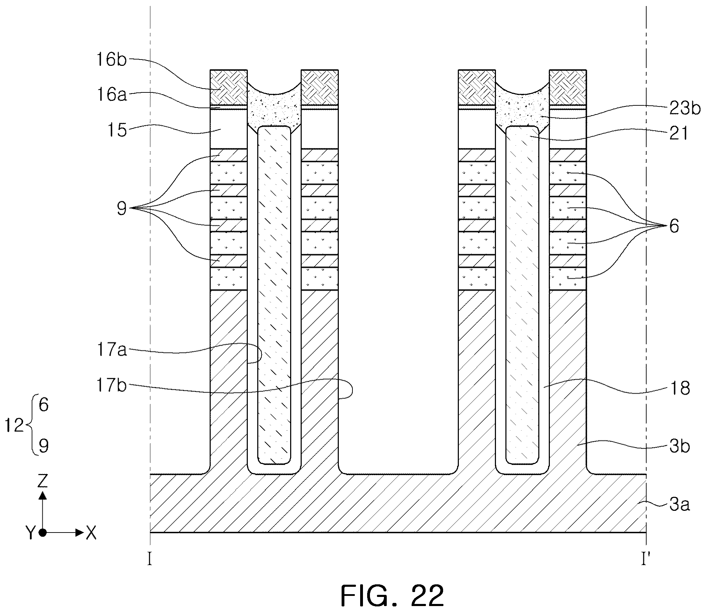

Referring to FIG. 22, the second separation insulating layer 23a may be isotropically etched to form preliminary separation insulating patterns 23b remaining on upper surfaces of the first separation patterns 21 and the insulating liner 18.

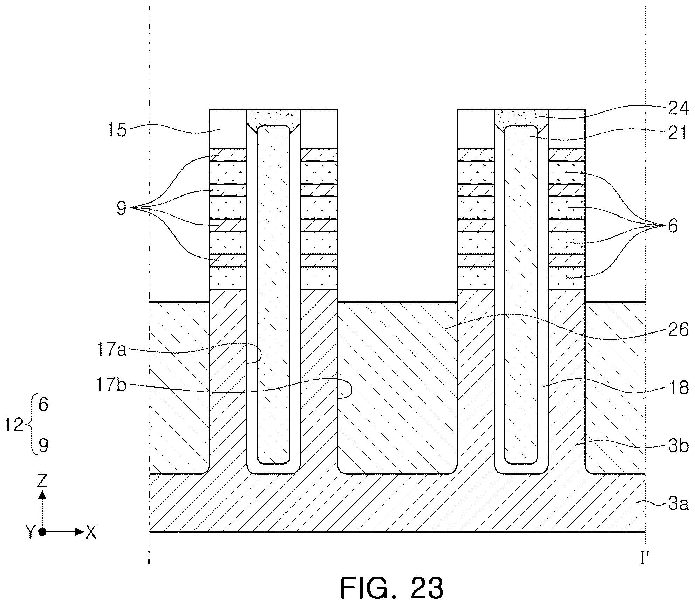

Referring to FIG. 23, an element isolation insulating layer may be formed on a resulting structure formed up to the preliminary separation insulating patterns 23b, the element isolation insulating layer may be flattened until the capping layer 15 is exposed, and the flattened element isolation insulating layer may be partially etched, thereby forming element isolation insulating patterns 26 filling lower regions of the second trenches 17b. Upper surfaces of the element isolation insulating patterns 26 may be formed at a lower level than that of the stack patterns 12. While the element isolation insulating layer is flattened until the capping layer 15 is exposed, the mask patterns 16a and 16b (see FIG. 22) may be removed. The preliminary separation insulating patterns 23b may be formed as second separation patterns 24.

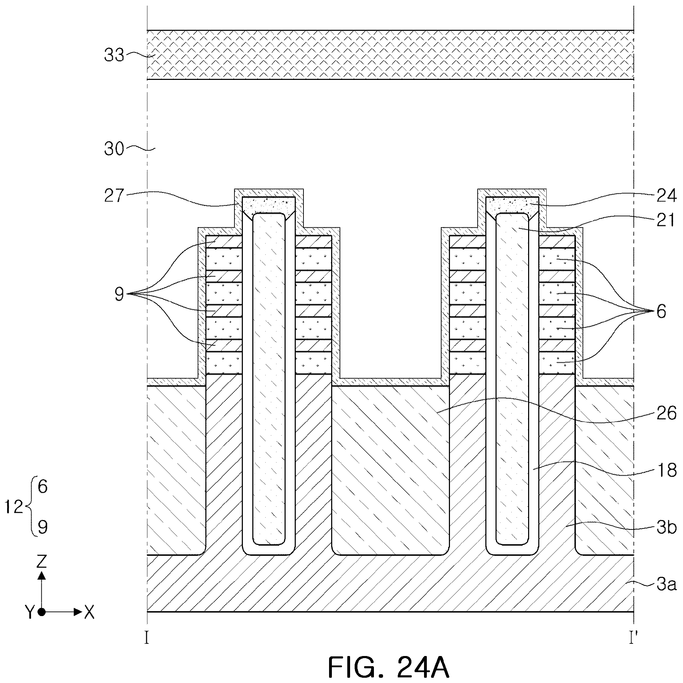

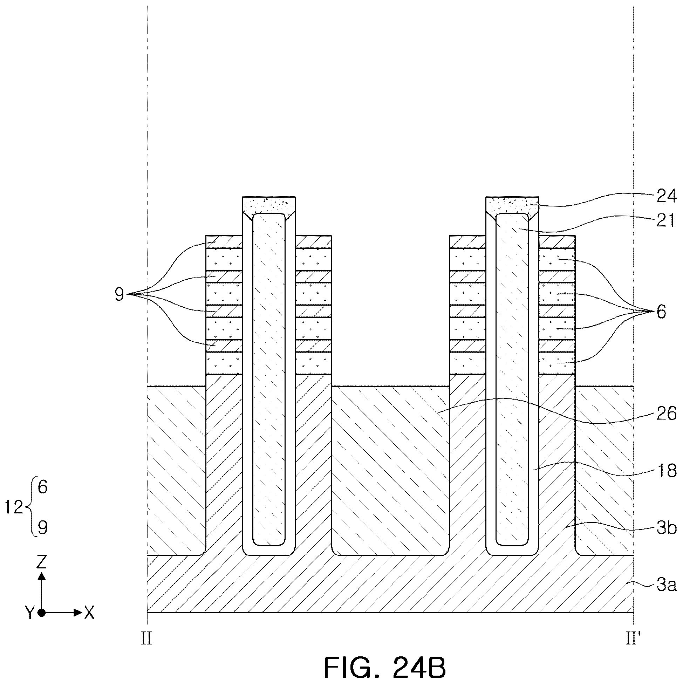

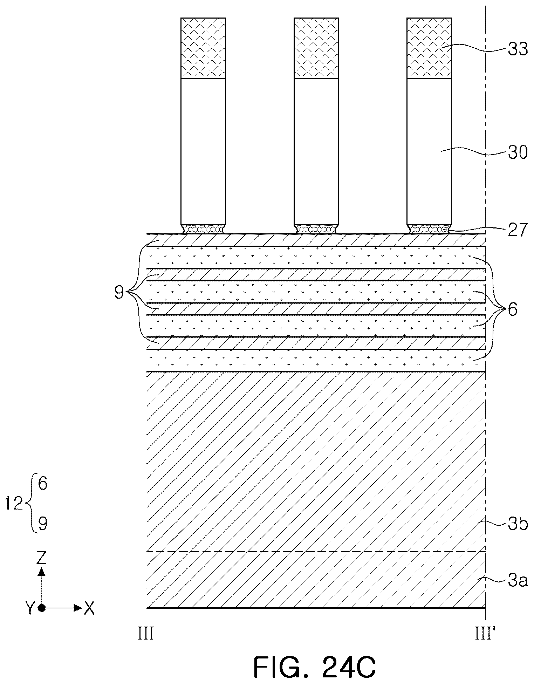

Referring to FIGS. 24A, 24B, and 24C, sacrificial gate lines 27, 30 and 33 may be formed. Each of the sacrificial gate lines 27, 30 and 33 may extend in the first horizontal direction (X-direction). Each of the sacrificial gate lines 27, 30 and 33 may include a buffer oxide layer 27, a sacrificial gate electrode layer 30 on the buffer oxide layer 27, and a sacrificial gate mask layer 33.

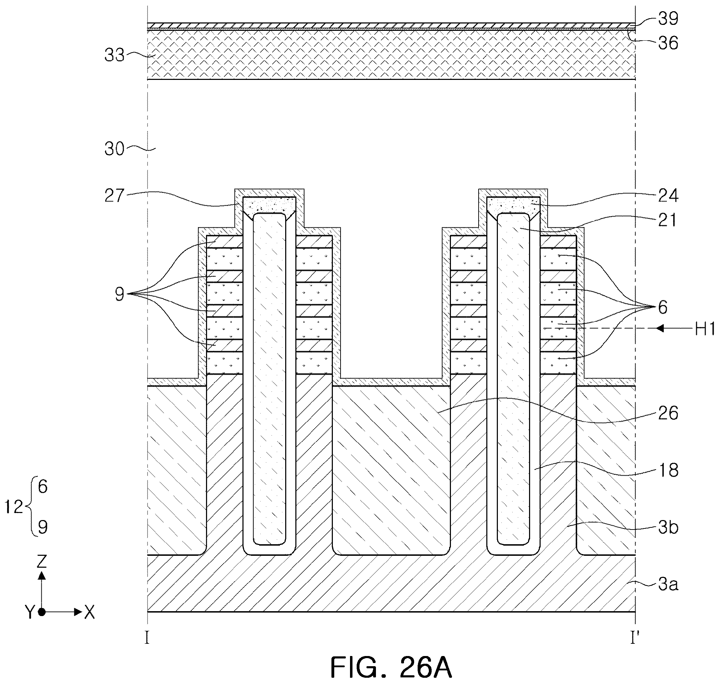

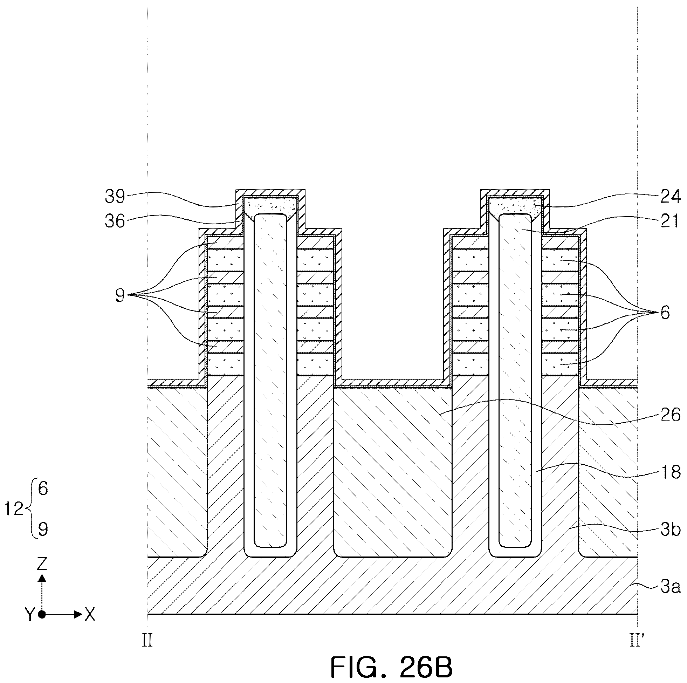

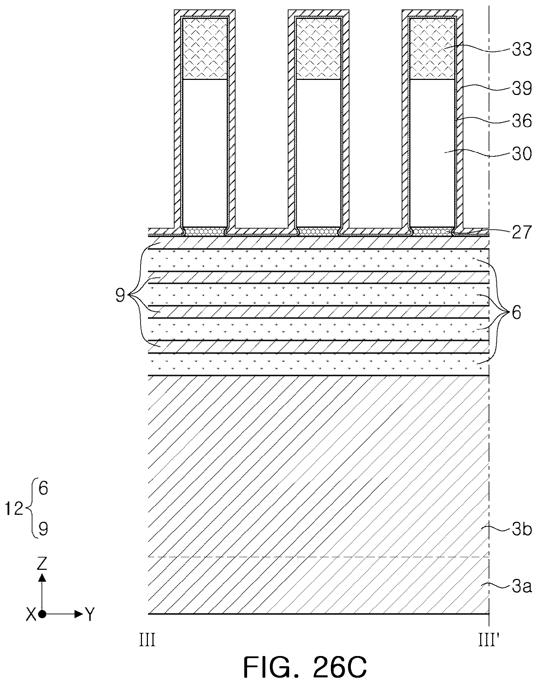

Referring to FIGS. 25, 26A, 26B, and 26C, spacer material layers 39 and 36 conformally covering the sacrificial gate lines 27, 30 and 33 and surfaces between the sacrificial gate lines 27, 30 and 33 exposed by the sacrificial gate lines 27, 30 and 33 may be formed. The spacer material layers 39 and 36 may include a second spacer material layer 36 and a first spacer material layer 39 on the second spacer material layer 36.

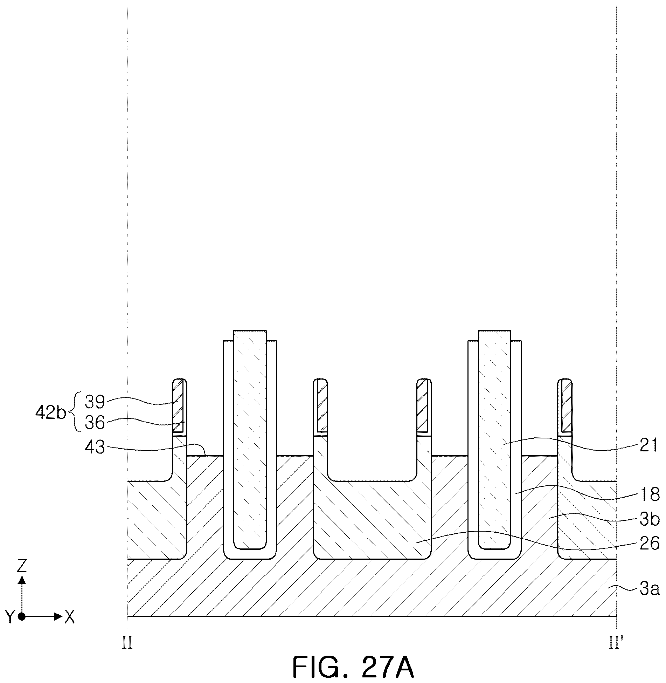

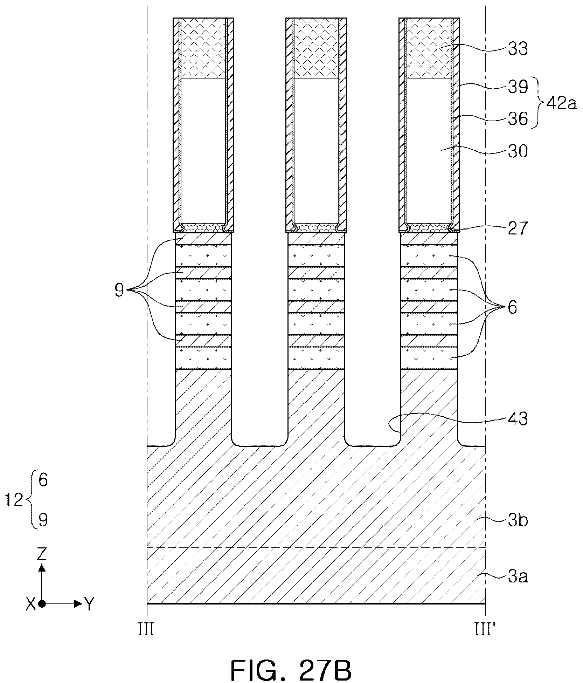

Referring to FIGS. 25, 27A and 27B, the spacer material layers 39 and 36 may be anisotropically etched to form gate spacers 42a remaining on side surfaces of the sacrificial gate lines 27, 30 and 33, and residual spacers 42b remaining on the element isolation insulating patterns 26. Then, the stack patterns 12 may be etched to form source/drain recesses 43. The source/drain recesses 43 may extend into the protrusion portions 3b. Lower surfaces of the source/drain recesses 43 may be formed at a lower level than that of the stack patterns 12. The lower surfaces of the source/drain recesses 43 may be formed at a lower level than that of the residual spacers 42b. While forming the source/drain recesses 43, a portion of the element isolation insulating patterns 26 may be etched. While forming the source/drain recesses 43, the second separation patterns 24 disposed on the first separation patterns 21 disposed between the protrusion portions 3b may be etched and removed, and the first separation patterns 21 and the insulating liner 18 may be partially etched to lower upper surfaces thereof.

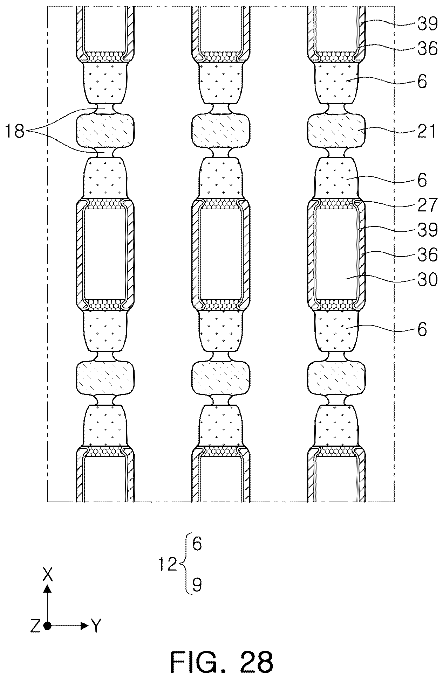

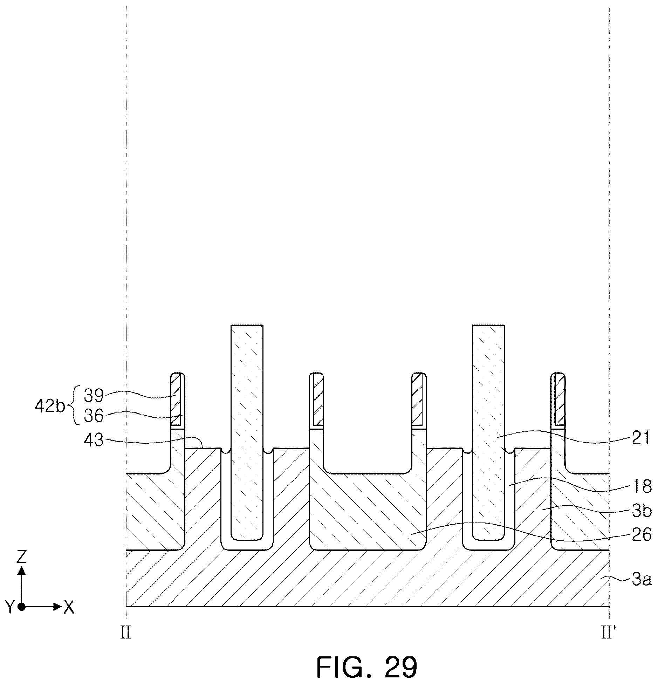

Referring to FIGS. 28 and 29, the insulating liner 18 may be partially etched. Accordingly, in a plan view as in FIG. 28, the insulating liner 18 may be formed to have both concave side surfaces in the second horizontal direction (Y-direction), and in a cross-sectional view as in FIG. 29, the insulating liner 18 may be formed to have a concave upper surface. In the second horizontal direction (Y-direction), a width of the insulating liner 18 may be smaller than a width of each of the stack patterns 12.

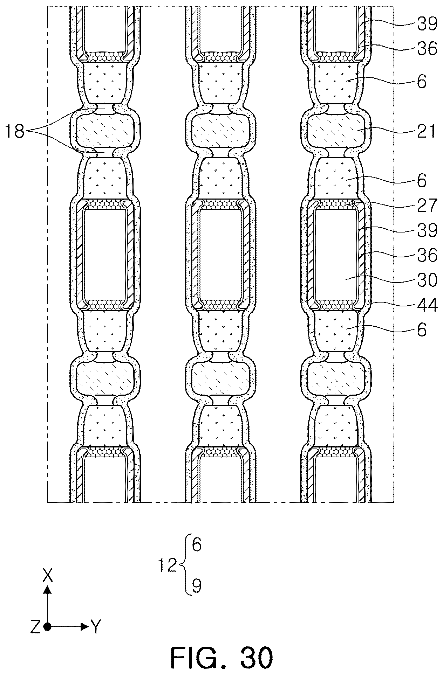

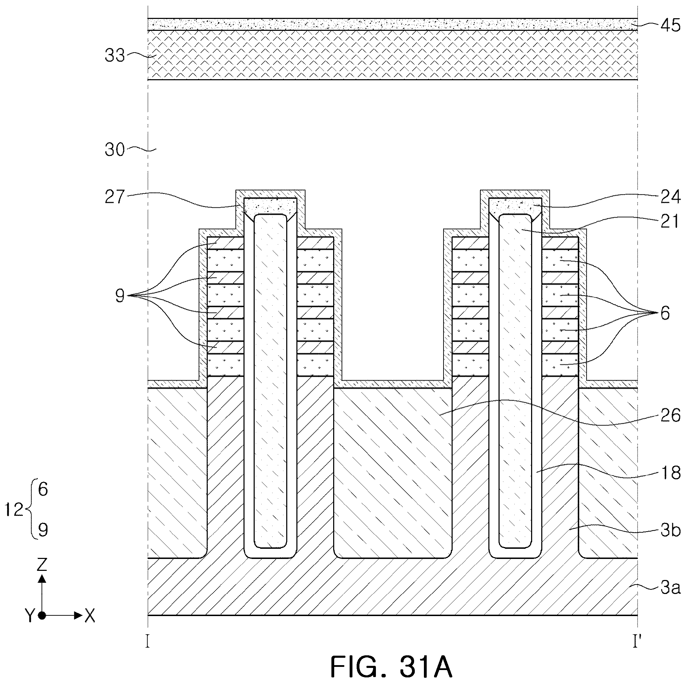

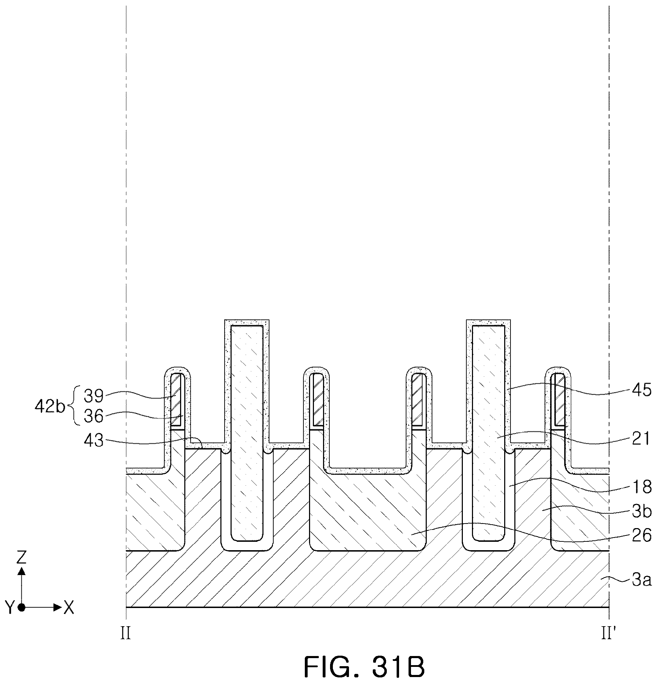

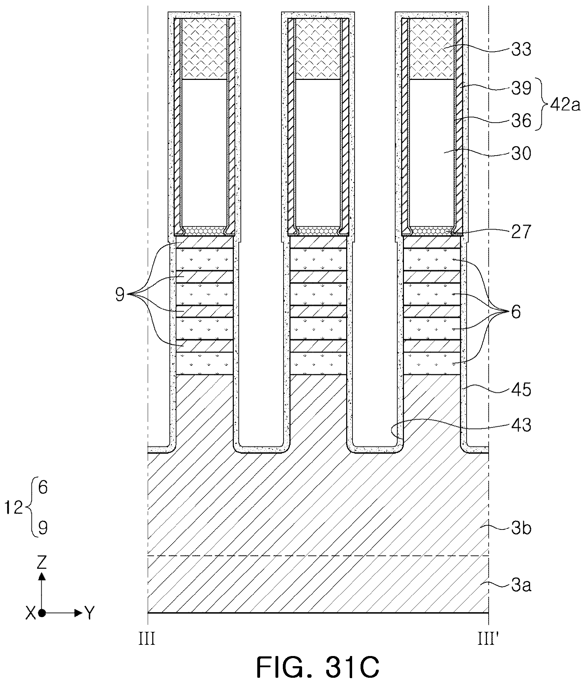

Referring to FIGS. 30, 31A, 31B and 31C, as in FIGS. 18 and 29, after the insulating liner 18 is partially etched, a spacer material layer 44 may be conformally formed. The spacer material layer 44 may include at least one of SiN, SiOCN, SiOC, SiBN, or SiCN.

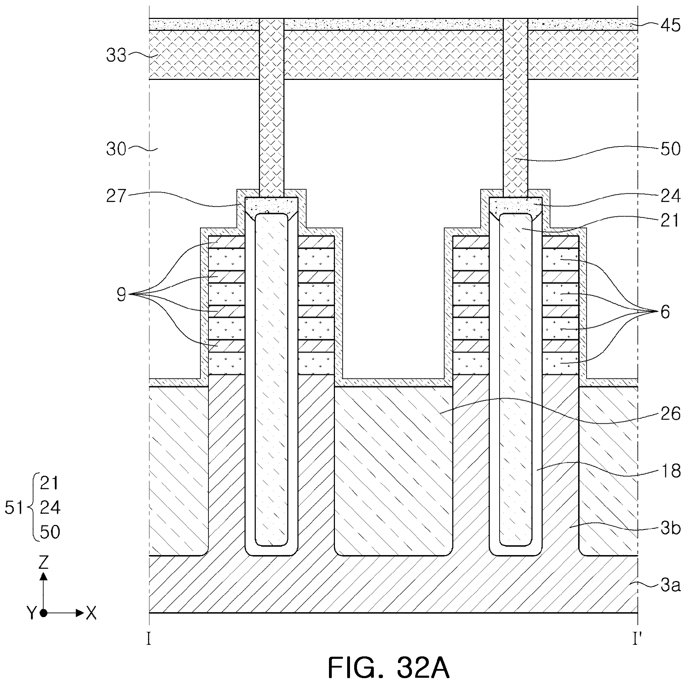

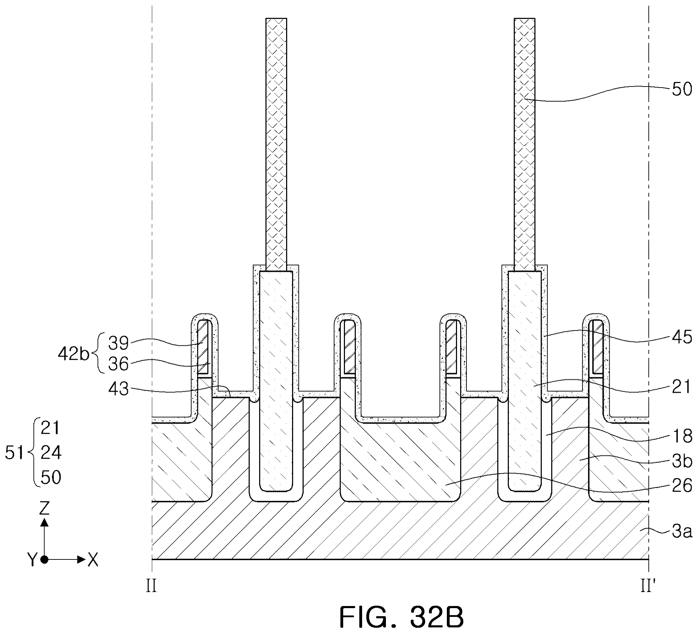

Referring to FIGS. 32A and 32B, third separation patterns 50 may be formed. The third separation patterns 50 may penetrate through the spacer material layer 44 and the sacrificial gate lines 27, 30 and 33 and may contact the second separation patterns 24, and may penetrate through the spacer material layer 44 between the sacrificial gate lines 27, 30 and 33 and may contact the first separation patterns 21. Accordingly, separation structures 51 including the first separation pattern 21, the second separation pattern 24 and the third separation pattern 50 may be formed, respectively.

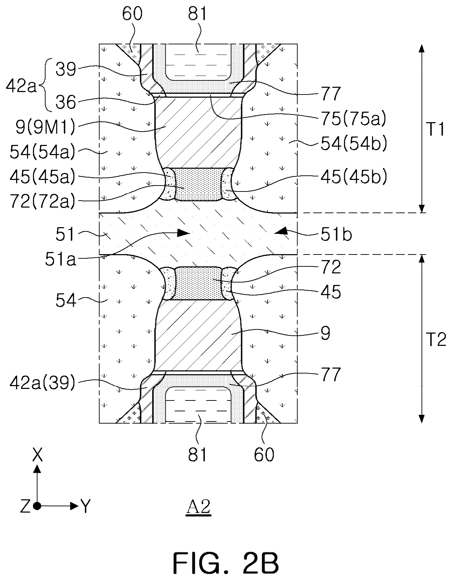

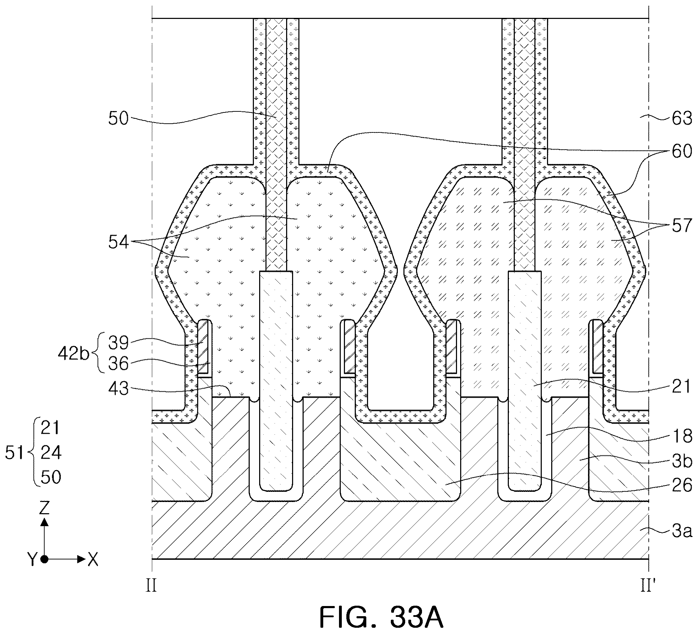

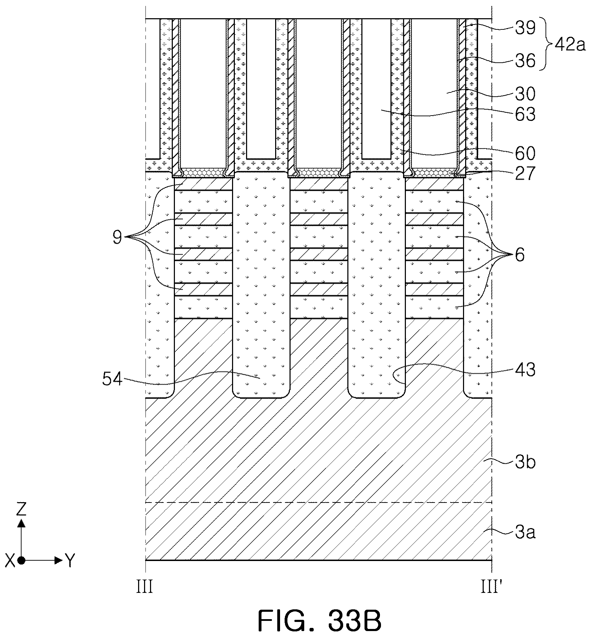

Referring to FIGS. 33A and 33B along with FIGS. 1A, 1B, 2A and 2B, the spacer material layer 44 may be isotropically etched to form insulating spacers 45 (see FIGS. 1B and 2B). Then, a source/drain formation process may be performed to form source/drain regions 54 and 57 within the source/drain recesses 43. Forming the source/drain regions 54 and 57 may include using a selective epitaxial growth process. The insulating spacers 45 (see FIGS. 1B and 2B) may prevent bridge failures from occurring between the source/drain regions 54 and 57 adjacent to each other in the second horizontal direction (Y-direction) and adjacent to the separation structures 51.

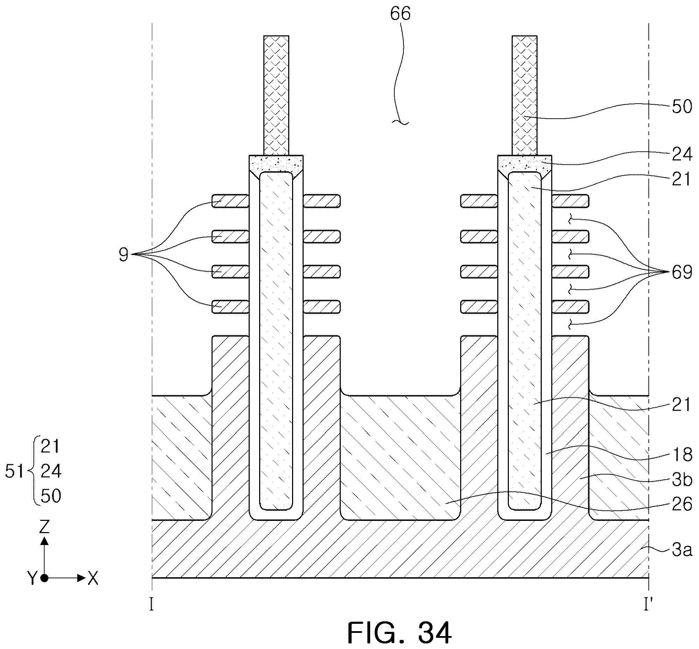

Referring to FIG. 34, the sacrificial gate lines 27, 30 and 33 may be removed to form gate trenches 66. The sacrificial layers 6 exposed by the gate trenches 66 may be selectively removed to form empty spaces 69.

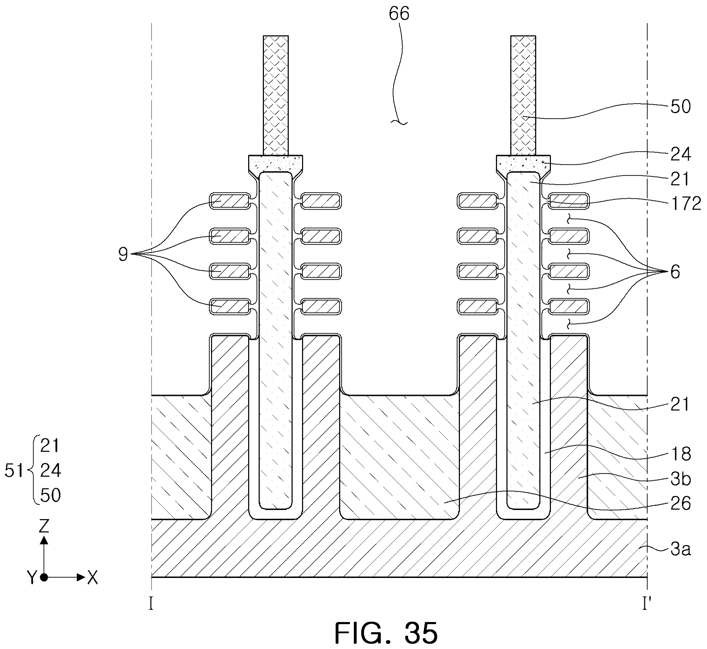

Referring to FIG. 35, after the gate trenches 66 and the empty spaces 69 are formed, an insulating pattern 172 may be formed. The insulating pattern 172 may be formed by partially etching the insulating liner 18 disposed at a higher level than the protrusion portions 3b.

FIG. 35 illustrates that the insulating pattern 172 described in FIGS. 7 and 12 is formed, but embodiments are not limited thereto. For example, the insulating liner 18 disposed at a higher level than the protrusion portions 3b may be partially etched to form insulating patterns 172 as in FIG. 1A, 1B, 2A, 2B, 3A, 3B, 5A and 5B, insulating patterns 272 as in FIG. 8, or insulating patterns 372 as in FIG. 9.

In one or more embodiments, the insulating liner 18 disposed at a higher level than that of the protrusion portions 3b may be removed to form empty spaces as in FIG. 10 or empty spaces as in FIG. 11 between the channel layers 9 and the separation structure 51.

Then, the first gate dielectric layer 75 may be formed. Forming the first gate dielectric layer 75 may include oxidizing surfaces of the exposed channel layers 9 and the protrusion portions 3b, forming an oxide layer, performing a process of densifying at least a portion of the oxide layer, and etching a portion of the densified oxide layer. Accordingly, the first gate dielectric layer 75 may be formed to include the first dielectric portion 75a and the second dielectric portion 75b as described in FIG. 5b.

Referring again to FIGS. 1A, 1B, 2A, 2B, 3A, 3B, 4, 5A and 5B, after forming the first gate dielectric layer 75, a second gate dielectric layer 77 conformally covering internal walls of the gate trenches 66 and the empty spaces 69 may be formed. Next, gate electrodes 81 and 82 filling the empty spaces 69 and partially filling the gate trenches 66 may be formed on the second gate dielectric layer 77, and a gate capping pattern 84 may be formed on the gate electrodes 81 and 82.

A gate separation pattern 86 penetrating through the gate capping pattern 84, passing between the gate electrode 81 of the second transistor structure T2 and the gate electrode 82 of the third transistor structure T3 and penetrating through the gate dielectric structure 79, and extending into the element separation insulating pattern 26 may be formed. The gate separation pattern 86 may include an insulating material of a nitride series.

According to an aspect of an example embodiment, a method of manufacturing a semiconductor device may include alternately stacking sacrificial layers and channel layers on a substrate, forming a capping layer, sequentially stacking a first mask pattern and a second mask pattern on the capping layer, forming trenches and stack patterns by etching the first mask pattern and the second mask pattern, forming an insulating liner in the trenches, forming a first separation insulating layer on the insulating liner, etching the first separation insulating layer to form first separation patterns, forming a second separation insulating layer on upper surfaces of the first separation patterns, etching the second separation insulating layer to form preliminary separation insulating patterns, forming element isolation insulating patterns by etching the preliminary separation insulating patterns, forming sacrificial gate lines, forming spacer material layers on the sacrificial gate lines, forming gate spacers by etching the spacer material layers, etching the stack patterns to form source/drain recesses, etching the insulating liner, forming a spacer material layer, forming third separation patterns penetrating the spacer material layer, etching the spacer material layer to form insulating spacers, forming source/drain regions within the source/drain recesses, removing the sacrificial gate lines to form gate trenches, forming an insulating pattern, forming a first gate dielectric layer, forming a second gate dielectric layer, forming gate electrodes, and forming a gate separation pattern.

According to one or more embodiments, a semiconductor device including a separation structure and a transistor structure may be provided.

In one or more embodiments, the transistor structure includes insulating spacers spaced apart from each other between source/drain regions adjacent to the separation structure. The insulating spacers may prevent leakage current from occurring between the source/drain regions adjacent to the separation structure, and may prevent the occurrence of a bridge failure in which the source/drain regions are connected to each other.

In one or more embodiments, the insulating spacers may prevent leakage current from occurring between an edge of a gate electrode of the transistor structure adjacent to the separation structure and the source/drain regions.

In one or more embodiments, a distance between the gate electrode of the transistor structure and the separation structure may be less than a distance between channel layers of the transistor structure and the separation structure. Accordingly, since a region in which the gate electrode and the channel layers face each other may be increased, the gate control ability of the transistor including the gate electrode and the channel layers may be increased.

Each of the embodiments provided in the above description is not excluded from being associated with one or more features of another example or another embodiment also provided herein or not provided herein but consistent with the disclosure.

While the disclosure has been particularly shown and described with reference to embodiments thereof, it will be understood that various changes in form and details may be made therein without departing from the scope of the following claims.

## Claims

1. A semiconductor device (1), comprising:
a separation structure (51); and
a transistor structure (T1; T2; T3; T4) on a side surface (51S1; 5152) of the separation structure (51),
wherein the transistor structure (T1; T2; T3; T4) comprises:
a first source/drain region (54a);
a second source/drain region (54b) spaced apart from the first source/drain region (54a);
channel layers (9) connected to the first source/drain region (54a) and the second source/drain region (54b), the channel layers (9) being spaced apart in a first direction;
a gate electrode (81; 82) covering each of the channel layers (9);
a gate dielectric structure (79) between the first source/drain region (54a) and the second source/drain region (54b) and the gate electrode (81; 82), between the channel layers (9) and the gate electrode (81; 82), and between the separation structure (51) and the gate electrode (81; 82); and
a first insulating spacer (45a) and a second insulating spacer (45b) spaced apart from each other, adjacent to the separation structure (51), and between the first source/drain region (54a) and the second source/drain region (54b).

2. The semiconductor device (1) of claim 1, wherein the transistor structure (T1; T2; T3; T4) further comprises gate spacers (42a) on side surfaces of the gate electrode (81; 82), and
wherein each of the first insulating spacer (45a) and the second insulating spacer (45b) is spaced apart from the gate spacers (42a) at a level that is lower than a level of an upper surface of an uppermost channel layer (9U) among the channel layers (9).

3. The semiconductor device (1) of claim 1 or 2, wherein the first insulating spacer (45a) contacts the first source/drain region (54a), and
wherein the second insulating spacer (45b) contacts the second source/drain region (54b).

4. The semiconductor device (1) of claim 3, wherein the first insulating spacer (45a) and the second insulating spacer (45b) contact the separation structure (51).

5. The semiconductor device (1) of any one of claims 1 to 4, wherein each of the channel layers (9) comprises a first side surface (9S1) facing the separation structure (51) and a second side surface (9S2) opposite the first side surface (9S1),
wherein the gate electrode (81; 82) covers a lower surface, an upper surface, and the first side surface (9S1) of each of the channel layers (9), and
wherein the gate electrode (81; 82) comprises:
a lower electrode portion (81L) below a lower surface of a lowermost channel layer (9L) among the channel layers (9) in the first direction;
an upper electrode portion (81U) on an upper surface of an uppermost channel layer (9U) among the channel layers (9) in the first direction; and
an intermediate electrode portion (81M) between channel layers (9), among the channel layers (9), that are adjacent to each other in the first direction and between the uppermost channel layer (9U) and the lowermost channel layer (9L).

6. The semiconductor device (1) of claim 5, wherein a distance between the channel layers (9) and the separation structure (51) is greater than a distance between the intermediate electrode portion (81M) and the separation structure (51).

7. The semiconductor device (1) of claim 5 or 6, wherein the intermediate electrode portion (81M) comprises:
a first electrode portion (81a) between the channel layers (9) adjacent to each other in the first direction; and
a second electrode portion (81b) extending in a second direction oriented toward the separation structure (51) from the first electrode portion (81a), and
wherein, in the intermediate electrode portion (81M), a thickness of the second electrode portion (81b) in the first direction is greater than a thickness of the first electrode portion (81a) in the first direction.

8. The semiconductor device (1) of claim 5, 6, or 7, further comprising an insulating pattern (72),
wherein the insulating pattern (72) comprises first portions (72a) and second portions (72b) extending from the first portions (72a),
wherein the first portions (72a) of the insulating pattern (72) are between the channel layers (9) and the separation structure (51), and
wherein the second portions (72b) of the insulating pattern (72) are between the lower electrode portion (81L) and the separation structure (51), between the intermediate electrode portion (81M) and the separation structure (51), and between the upper electrode portion (81U) and the separation structure (51).

9. The semiconductor device (1) of claim 8, wherein the channel layers (9) face the separation structure (51) in a third direction intersecting the first direction,
wherein the first source/drain region (54a) and the second source/drain region (54b) are spaced apart from each other in a fourth direction that is perpendicular to the third direction, and
wherein the first insulating spacer (45a) and the second insulating spacer (45b) are spaced apart from each other in the fourth direction.

10. The semiconductor device (1) of claim 9, wherein, in the insulating pattern (72), a thickness of each of the first portions (72a) in the third direction is greater than a thickness of each of the second portions (72b) in the third direction.

11. The semiconductor device (1) of any one of claims 5 to 10, further comprising insulating patterns (72) between the channel layers (9) and the separation structure (51), the insulating patterns (72) being spaced apart in the first direction.

12. The semiconductor device (1) of any one of claims 8 to 11, wherein the separation structure (51) comprises a first insulating material, and
wherein the insulating patterns (72) comprise a second insulating material different from the first insulating material.

13. The semiconductor device (1) of any one of claims 1 to 12, wherein the separation structure (51) comprises:
a first separation region (51a) adjacent to the gate electrode (81; 82), the gate dielectric structure (79), and the channel layers (9); and
a second separation region (51b) adjacent to the first source/drain region (54a) and the second source/drain region (54b).

14. The semiconductor device (1) of claim 13, wherein the first separation region (51a) of the separation structure (51) comprises:
a first separation pattern (21) having a lower surface at a level that is lower than a level of a lowermost channel layer (9L) among the channel layers (9), and an upper surface at a level that is higher than a level of an uppermost channel layer (9U) among the channel layers (9); and
a second separation pattern (24) covering the upper surface of the first separation pattern (21) and having a width that is greater than a width of the first separation pattern (21).

15. The semiconductor device (1) of claim 14, wherein the first separation region (51a) is spaced apart from the channel layers (9), and
wherein the second separation region (51b) contacts the first source/drain region (54a) and the second source/drain region (54b).
